# EUROPEAN PATENT APPLICATION

(11) **EP 4 514 106 A1**
(43) Date of publication of application: **26.02.2025**
(21) Application number: 24193974.3
(22) Date of filing: 09.08.2024
(51) Int. Cl.: H10K 59/122, H10K 59/124, H10K 59/131, H10K 59/40, H10K 59/65, H10K 59/80, H10K 59/88

(54) **DISPLAY PANEL**

(30) Priority: 21.08.2023 KR 20230109166
(71) Applicant: Samsung Display Co., Ltd., Gyeonggi-Do (KR)
(72) Inventor: LEE, Jeongho, Yongin-si (KR); KIM, Jin-Yup, Yongin-si (KR); LEE, Hongbeom, Yongin-si (KR)
(74) Representative: Marks & Clerk LLP

(57) **Abstract**

Disclosed is a display panel which includes a base layer having a hole, a circuit layer disposed on the base layer and including a pixel circuit and a plurality of insulating layers, an element layer disposed on the circuit layer and including a light emitting element electrically connected to the pixel circuit and a pixel defining layer defining an emissive region, and an encapsulation layer covering the element layer. The circuit layer further includes a groove surrounding the hole, and the pixel defining layer includes a valley surrounding at least a portion of the emissive region. A bottom surface of the groove and side surfaces of the groove connected to the bottom surface are formed by an insulating layer among the plurality of insulating layers.

## Description

### BACKGROUND

### 1. Technical Field

Embodiments relate to a display panel with a simplified manufacturing process and improved product reliability.

### 2. Description of the Related Art

A display device may be a device formed by various electronic parts, such as a display panel that displays an image, an input sensor that senses an external input, an electronic module, and the like. The electronic module may include a camera, an infrared sensor, a proximity sensor, or the like. The electronic module may be disposed under the display panel and the input sensor. A hole for exposing the electronic module may be provided in the display panel and the input sensor.

### SUMMARY

Embodiments provide a display panel with a simplified manufacturing process and improved product reliability.

According to an embodiment, a display panel includes a base layer having a hole, a circuit layer disposed on the base layer and including a pixel circuit and a plurality of insulating layers, an element layer disposed on the circuit layer and including a light emitting element electrically connected to the pixel circuit and a pixel defining layer defining an emissive region, and an encapsulation layer covering the element layer. The circuit layer further includes a groove surrounding the hole, and the pixel defining layer includes a valley surrounding at least a portion of the emissive region. A bottom surface of the groove and side surfaces of the groove connected to the bottom surface are formed by an insulating layer among the plurality of insulating layers.

The circuit layer may further include a first tip portion surrounding the hole and a second tip portion surrounding the first tip portion, and the first tip portion and the second tip portion may protrude from the respective side surfaces of the groove.

A depth of the valley may be substantially the same as a height of the first tip portion, which is measured from the bottom surface of the groove to a bottom surface of the first tip portion.

A difference between the height of the first tip portion and a width of the first tip portion may be less than about 0.15 micrometers.

Each of the side surfaces of the groove may include a curved surface extending from the bottom surface and a tapered surface extending from the curved surface.

The valley may be formed by a valley bottom surface, a valley curved surface extending from the valley bottom surface, and a valley tapered surface extending from the valley curved surface, and the valley curved surface may have substantially the same shape as the curved surface of the groove.

An angle between the valley bottom surface and the valley tapered surface may be substantially the same as an angle between the bottom surface of the groove and the tapered surface of the groove.

The groove may include a plurality of grooves, and the encapsulation layer may include a first encapsulation layer covering the plurality of grooves, a second encapsulation layer disposed on the first encapsulation layer to overlap some of the plurality of grooves and so as not to overlap the other grooves of the plurality of grooves, and a third encapsulation layer disposed on the second encapsulation layer to cover the plurality of grooves.

The display panel may further include a sensor layer disposed on the encapsulation layer and including a first sensor conductive layer, a sensor insulating layer disposed on the first sensor conductive layer, and a second sensor conductive layer disposed on the sensor insulating layer, and at least one of the first sensor conductive layer and the second sensor conductive layer may include a clad pattern overlapping the other grooves.

The circuit layer may further include a crack dam disposed between the groove and the hole, and the crack dam may include a tip portion protruding toward the hole. The clad pattern may overlap the crack dam and the tip portion.

The display panel may further include a cover layer disposed on the third encapsulation layer and overlapping the plurality of grooves.

The circuit layer may further include a crack dam disposed between the groove and the hole, and the crack dam may include a tip portion protruding toward the hole.

The circuit layer may further include at least one inorganic pattern disposed between the groove and the hole, and the at least one inorganic pattern may include the same materials as inorganic insulating layers among the plurality of insulating layers of the circuit layer.

The insulating layer among the plurality of insulating layers may be an organic insulating layer.

The light emitting element may include a first electrode, an intermediate layer disposed on the first electrode, and a second electrode disposed on the intermediate layer, and a portion of the intermediate layer and a portion of the second electrode may be disposed in the valley.

The intermediate layer may include a first functional layer, an emissive layer disposed on the first functional layer, and a second functional layer disposed on the emissive layer, and a portion of the first functional layer, a portion of the second functional layer, and a portion of the second electrode may be disposed in the groove.

The bottom surface of the groove may have a lower roughness than a valley bottom surface of the valley.

The light emitting element may include a first electrode, an intermediate layer disposed on the first electrode, and a second electrode disposed on the intermediate layer, and an indium-gallium-zinc oxide (IGZO) residue may be disposed on an upper surface of the first electrode.

According to an embodiment, a display panel may include a base layer having a hole, a circuit layer disposed on the base layer and including a plurality of grooves to surround the hole and includes a plurality of tip portions protruding from a side surface of each of the plurality of grooves, an element layer disposed on the circuit layer and including a pixel defining layer defining an emissive region, and an encapsulation layer covering the element layer. The pixel defining layer may include a valley surrounding at least a portion of the emissive region and formed in an upper surface of the pixel defining layer, and a depth of the valley may be substantially the same as heights of the plurality of tip portions, which are measured from bottom surfaces of the plurality of grooves to bottom surfaces of the plurality of tip portions.

The circuit layer may further include a plurality of insulating layers. An insulating layer among the plurality of insulating layers may form the bottom surfaces of the plurality of grooves and side surfaces of the plurality of grooves extending from the bottom surfaces. The insulating layer among the plurality of insulating layers may be an organic insulating layer.

The circuit layer may further include at least one inorganic pattern disposed between the plurality of grooves and the hole, and the at least one inorganic pattern may include the same materials as inorganic insulating layers among the plurality of insulating layers of the circuit layer.

The circuit layer may further include a crack dam disposed between the plurality of grooves and the hole, and the crack dam may include a tip portion protruding toward the hole.

The display panel may further include a sensor layer disposed on the encapsulation layer and including a first sensor conductive layer, a sensor insulating layer disposed on the first sensor conductive layer, and a second sensor conductive layer disposed on the sensor insulating layer. The encapsulation layer may include a first encapsulation layer covering the plurality of grooves, a second encapsulation layer disposed on the first encapsulation layer to overlap some of the plurality of grooves and so as not to overlap the other grooves of the plurality of grooves, and a third encapsulation layer disposed on the second encapsulation layer to cover the plurality of grooves. At least one of the first sensor conductive layer and the second sensor conductive layer may include a clad pattern overlapping the other grooves.

The display panel may further include a plurality of dams formed between adjacent grooves among the plurality of grooves, and the number of the plurality of tip portions may be twice the number of the plurality of dams.

At least some of the above and other features of the invention are set out in the claims.

### BRIEF DESCRIPTION OF THE DRAWINGS

The above and other objects and features of the disclosure will become apparent by describing in detail embodiments thereof with reference to the accompanying drawings.
FIG. 1A is a schematic perspective view of an electronic device according to an embodiment.
FIG. 1B is a schematic plan view of an electronic device according to an embodiment.
FIG. 2 is a block diagram of an electronic device according to an embodiment.
FIG. 3 is a schematic sectional view of the electronic device according to an embodiment.
FIG. 4 is a block diagram illustrating some components of the electronic device according to an embodiment.
FIG. 5 is a schematic diagram of an equivalent circuit of a pixel according to an embodiment.
FIG. 6 is a schematic plan view illustrating a portion of a display panel according to an embodiment.
FIG. 7 is a schematic sectional view of the display panel according to an embodiment.
FIG. 8A is an enlarged schematic sectional view illustrating a portion of the display panel according to an embodiment.
FIG. 8B is an enlarged schematic sectional view illustrating a portion of the display panel according to an embodiment.
FIG. 9 is an image of a portion of the display panel according to an embodiment.
FIG. 10 is an enlarged schematic plan view illustrating a portion of the display panel according to an embodiment.
FIG. 11A is a schematic sectional view of the display panel according to an embodiment.
FIG. 11B is a schematic sectional view of a display panel according to an embodiment.
FIG. 11C is a schematic sectional view of a display panel according to an embodiment.
FIG. 12A is a schematic sectional view of a display panel according to an embodiment.
FIG. 12B is a schematic sectional view of the display panel according to an embodiment;
FIG. 12C is a schematic sectional view of the display panel according to an embodiment.
FIG. 13 is an image of a portion of the display panel according to an embodiment.
FIG. 14 is a schematic sectional view of a display panel according to an embodiment.
FIG. 15 is a schematic sectional view of a display panel according to an embodiment.
FIG. 16 is a schematic sectional view of a display panel according to an embodiment.
FIG. 17 is a schematic sectional view of a display panel according to an embodiment.
FIG. 18 is an enlarged schematic sectional view illustrating a portion of a display panel according to an embodiment.
FIG. 19 is an enlarged schematic sectional view illustrating a portion of a display panel according to an embodiment.
FIGS. 20A, 20B, 21A, 21B, 22A, 22B, 23A, 23B, 24A, and 24B are schematic sectional views illustrating some steps of a display panel manufacturing process according to an embodiment.
FIGS. 25A, 25B, 26A, 26B, 27A, 27B, 28A, and 28B are schematic sectional views illustrating some steps of a display panel manufacturing process according to an embodiment.

### DETAILED DESCRIPTION OF THE EMBODIMENTS

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element or a layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction DR1, the axis of the second direction DR2, and the axis of the third direction DR3 are not limited to three axes of a rectangular coordinate system, such as the X, Y, and Z - axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this disclosure, "at least one of A and B" may be understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

Hereinafter, embodiments will be described with reference to the accompanying drawings.

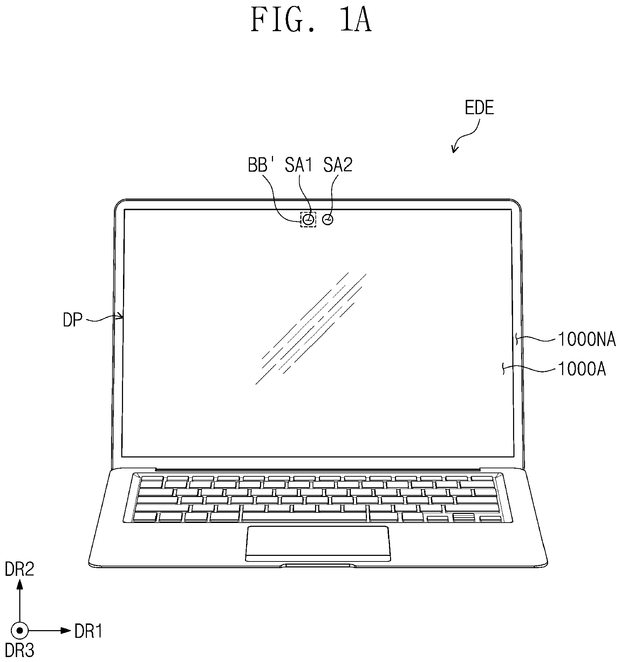

FIG. 1A is a schematic perspective view of an electronic device EDE according to an embodiment.

Referring to FIG. 1A, the electronic device EDE may be a device activated according to an electrical signal. The electronic device EDE may be used not only for large electronic devices, such as a television and a billboard, but also for small and medium-sized electronic devices, such as a personal computer, a notebook computer, a personal digital assistant, a car navigation unit, a game machine, a portable electronic device, and a camera. However, these devices are examples, and the electronic device EDE may be utilized for other electronic devices without departing from the scope of the disclosure. FIG. 1A illustrates an example that the electronic device EDE is a notebook computer.

The electronic device EDE may include a display panel DP. The display panel DP may be a component that displays an image. The display panel DP may be a light emitting display panel. For example, the display panel DP may be an organic light emitting display panel, an inorganic light emitting display panel, an organic-inorganic light emitting display panel, a quantum-dot display panel, a micro-LED display panel, or a nano-LED display panel.

In an embodiment, the display panel DP may further include a function of sensing an external input. For example, the display panel DP may sense at least one of an active input by an input device and a passive input by a touch. The touch may use all input means, such as a part of a user's body and an input device (e.g., a pen), which are capable of causing a change in capacitance.

The display panel DP may have an active region 1000A and a peripheral region 1000NA. The display panel DP may display an image through the active region 1000A. The active region 1000A may include a plane defined by a first direction DR1 and a second direction DR2. The peripheral region 1000NA may surround the periphery of the active region 1000A. In another example, the peripheral region 1000NA may be omitted.

One or more sensor regions SA1 and SA2 may be defined in the active region 1000A. Although two sensor regions SA1 and SA2 are illustrated as an example in FIG. 1A, the number of sensor regions SA1 and SA2 formed in the display panel DP is not limited thereto. Each of the sensor regions SA1 and SA2 may overlap at least one sensor. For example, each of the sensor regions SA1 and SA2 may overlap a front camera module, an illuminance sensor, a proximity sensor, an infrared camera, or a dot projector.

In an embodiment, the sensor regions SA1 and SA2 may be inactive regions that do not display an image and do not sense a touch. For example, the sensor regions SA1 and SA2 may be surrounded by the active region 1000A.

The thickness direction of the display panel DP may be parallel to a third direction DR3 intersecting the first direction DR1 and the second direction DR2. Accordingly, front surfaces (or upper surfaces) and rear surfaces (or lower surfaces) of members of the display panel DP may be defined based on the third direction DR3.

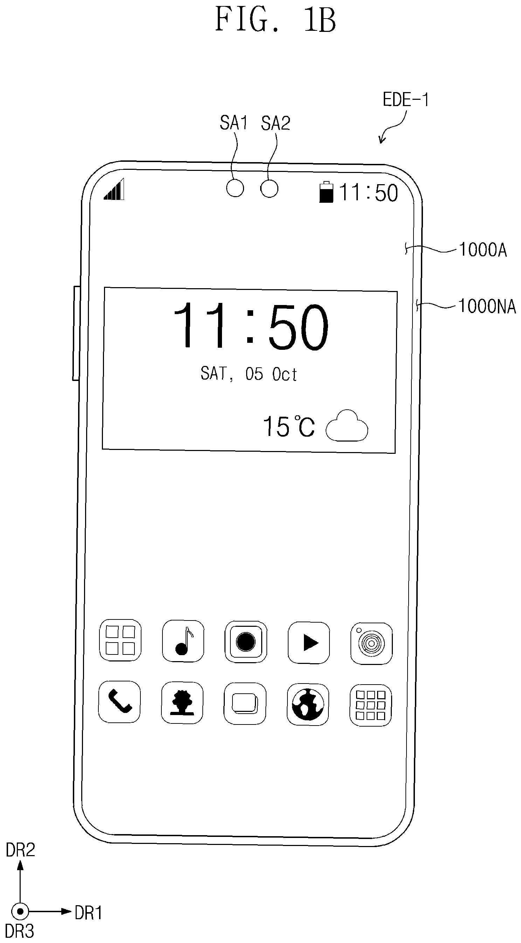

FIG. 1B is a schematic plan view of an electronic device EDE-1 according to an embodiment.

Referring to FIG. 1B, the electronic device EDE-1 is a bar-type mobile phone. Although the bar-type electronic device EDE-1 is illustrated as an example in FIG. 1B, embodiments are not limited thereto. For example, the following descriptions may be applied to various electronic devices such as a foldable electronic device EDE-1, a rollable electronic device EDE-1, or a slidable electronic device EDE-1.

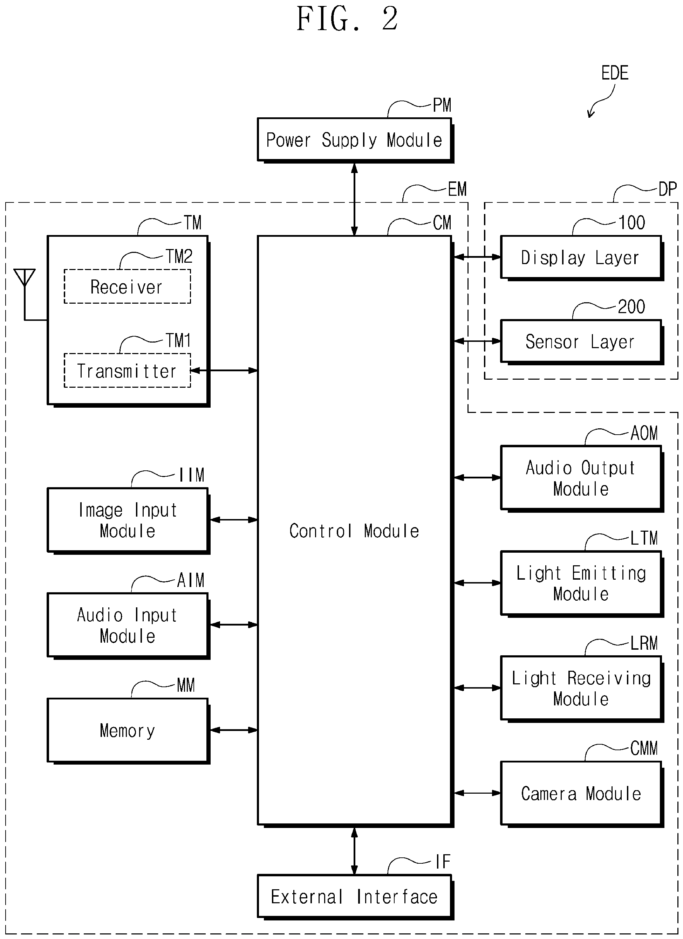

FIG. 2 is a block diagram of the electronic device EDE according to an embodiment.

Referring to FIG. 2, the electronic device EDE may include the display panel DP, an electronic module EM, and a power supply module PM.

The display panel DP may include a display layer 100 and a sensor layer 200. The display layer 100 may be a component that substantially generates an image. The display layer 100 may be a light emitting display layer. For example, the display layer 100 may be an organic light emitting display layer, an inorganic light emitting display layer, an organic-inorganic light emitting display layer, a quantum-dot display layer, a micro-LED display layer, or a nano-LED display layer.

The sensor layer 200 may sense an external input applied from the outside. The external input may be a user input. The user input may include various types of external inputs such as a part of a user's body, light, heat, a pen, or pressure. In another example, the sensor layer 200 may be omitted.

The power supply module PM may supply power required for overall operation of the electronic device EDE. The power supply module PM may include a conventional battery module.

The electronic module EM may include various functional modules for operating the electronic device EDE. The electronic module EM may be mounted (e.g., directly mounted) on a mother board electrically connected to the display panel DP, or may be mounted on a separate circuit board and electrically connected to the mother board through a connector.

The electronic module EM may include a control module CM, a wireless communication module TM, an image input module IIM, an audio input module AIM, a memory MM, an external interface IF, an audio output module AOM, a light emitting module LTM, a light receiving module LRM, and a camera module CMM.

The control module CM may control overall operation of the electronic device EDE. The control module CM may be a microprocessor. For example, the control module CM may activate or deactivate the display panel DP. The control module CM may control other modules, such as the image input module IIM or the audio input module AIM, based on a touch signal received from the display panel DP.

The wireless communication module TM may communicate with an external electronic device through a first network (e.g., a short-range communication network such as Bluetooth, WiFi direct, or infrared data association (IrDA)) or a second network (e.g., a long-range communication network such as a cellular network, Internet, or a computer network (e.g., LAN or WAN)). Communication modules included in the wireless communication module TM may be integrated into one component (e.g., a single chip), or may be implemented with components (e.g., chips) separated from one another. The wireless communication module TM may transmit/receive audio signals using a general communication line. The wireless communication module TM may include a transmitter TM1 that modulates a signal to be transmitted and transmits the modulated signal and a receiver TM2 that demodulates a received signal.

The image input module IIM may process an image signal to covert the image signal into image data that is able to be displayed on the display panel DP. The audio input module AIM may receive an external audio signal through a microphone in a voice recording mode or a voice recognition mode and may convert the external audio signal into electrical voice data.

The external interface IF may include a connector capable of physically connecting the electronic device EDE and an external electronic device. For example, the external interface IF may include a connector into which an external charger is inserted, a wired/wireless data port, or a card (e.g., memory card or SIMIUIM card) socket.

The audio output module AOM may convert audio data received from the wireless communication module TM or audio data stored in the memory MM and may output the converted data to the outside.

The light emitting module LTM may generate and output light. The light emitting module LTM may output infrared light. The light emitting module LTM may include an LED element. The light receiving module LRM may sense infrared light. The light receiving module LRM may be activated in the case that infrared light above a certain level is sensed. The light receiving module LRM may include a CMOS sensor. After infrared light generated by the light emitting module LTM is output, the infrared light may be reflected by an external object (e.g., the user's finger or face), and the reflected infrared light may be incident to the light receiving module LRM.

The camera module CMM may take a still image and a video. The camera module CMM may include camera modules. A part of the camera modules CMM may overlap at least one of the sensor regions SA1 and SA2 (refer to FIG. 1A). An external input (e.g., light) may be provided to the camera module CMM through at least one of the sensor regions SA1 and SA2. For example, the camera module CMM may take an external image by receiving natural light through at least one of the sensor regions SA1 and SA2.

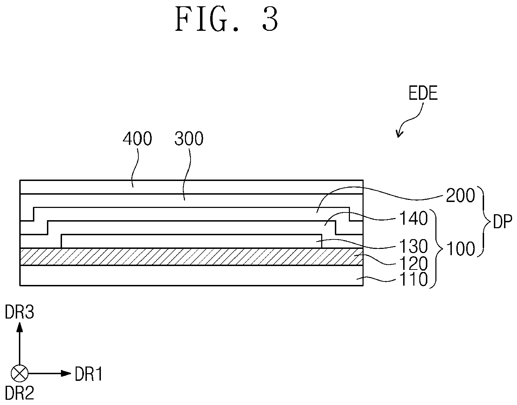

FIG. 3 is a schematic sectional view of the electronic device EDE according to an embodiment.

Referring to FIG. 3, the electronic device EDE may include the display panel DP, an anti-reflection layer 300, and a window 400. The display panel DP may include the display layer 100 and the sensor layer 200.

The display layer 100 may include a base layer 110, a circuit layer 120, an element layer 130, and an encapsulation layer 140.

The base layer 110 may be a member that provides a base surface on which the circuit layer 120 is disposed. The base layer 110 may be a rigid substrate, or a flexible substrate that is able to be bent, folded, or rolled. The base layer 110 may be a glass substrate, a metal substrate, a silicon substrate, or a polymer substrate. However, embodiments are not limited thereto, and the base layer 110 may be an inorganic layer, an organic layer, or a composite layer.

The circuit layer 120 may be disposed on the base layer 110. The circuit layer 120 may include an insulating layer, a semiconductor pattern, a conductive pattern, and a signal line. An insulating layer, a semiconductor layer, and a conductive layer may be formed on the base layer 110 by a process such as coating or deposition and may be selectively subjected to patterning by performing a photolithography process a plurality of times. Thereafter, the semiconductor pattern, the conductive pattern, and the signal line included in the circuit layer 120 may be formed.

The element layer 130 may be disposed on the circuit layer 120. The element layer 130 may include light emitting elements. For example, the element layer 130 may include an organic luminescent material, an inorganic luminescent material, an organic-inorganic luminescent material, a quantum dot, a quantum rod, a micro-LED, or a nano-LED.

The encapsulation layer 140 may be disposed on the element layer 130. The encapsulation layer 140 may protect the element layer 130 from foreign matter such as moisture, oxygen, and dust particles.

The sensor layer 200 may be disposed on the display layer 100. The sensor layer 200 may be formed on the display layer 100 through a continuous process. For example, the sensor layer 200 may be disposed (e.g., directly disposed) on the display layer 100. In the case that the sensor layer 200 is directly disposed on the display layer 100, this may mean that a third component is not disposed between the sensor layer 200 and the display layer 100. For example, a separate adhesive member may not be disposed between the sensor layer 200 and the display layer 100. In another example, the sensor layer 200 may be coupled with the display layer 100 through an adhesive member. The adhesive member may include a conventional adhesive or sticky substance.

The anti-reflection layer 300 may be disposed on the sensor layer 200. The anti-reflection layer 300 may decrease the reflectance of external light incident from outside the electronic device EDE (refer to FIG. 1A). The anti-reflection layer 300 may be disposed (e.g., directly disposed) on the sensor layer 200. However, embodiments are not limited thereto. For example, an adhesive member may be disposed between the anti-reflection layer 300 and the sensor layer 200.

The anti-reflection layer 300 may include color filters. The color filters may have a certain arrangement. For example, the color filters may be arranged in consideration of light emission colors of pixels included in the display layer 100. For example, the anti-reflection layer 300 may further include a black matrix adjacent to the color filters.

In another example, the anti-reflection layer 300 may include a reflection control layer. The reflection control layer may selectively absorb light in a partial band of light reflected inside the display panel DP and/or the electronic device EDE or light in a partial band of light incident from outside the display panel DP and/or the electronic device EDE. For example, the reflection control layer may absorb light outside the wavelength range of red light, green light, or blue light emitted from the display layer 100, and thus a decrease in the luminance of the display panel DP and/or the electronic device EDE may be prevented or minimized. For example, deterioration in the light emission efficiency of the display panel and/or the electronic device EDE may be prevented or minimized, and visibility may be improved.

In another case, the anti-reflection layer 300 may include a phase retarder and/or a polarizer. For example, the anti-reflection layer 300 may be attached to the sensor layer 200 by an adhesive layer. The phase retarder may be of a film type or a liquid-crystal coating type and may include a λ/2 phase retarder and/or a λ/4 phase retarder. The polarizer may be of a film type and may include a stretchable synthetic resin film. The phase retarder and the polarizer may further include a protective film. The phase retarder and the polarizer themselves or the protective film may be defined as a base layer of the anti-reflection layer 300.

The window 400 may be disposed on the anti-reflection layer 300. An adhesive member may be disposed between the anti-reflection layer 300 and the window 400. However, embodiments are not limited thereto. The window 400 may include an optically clear insulating material. For example, the window 400 may include glass or plastic. The window 400 may have a multi-layer structure or a single-layer structure. For example, the window 400 may include plastic films coupled by an adhesive, or may include a glass substrate and a plastic film coupled by an adhesive.

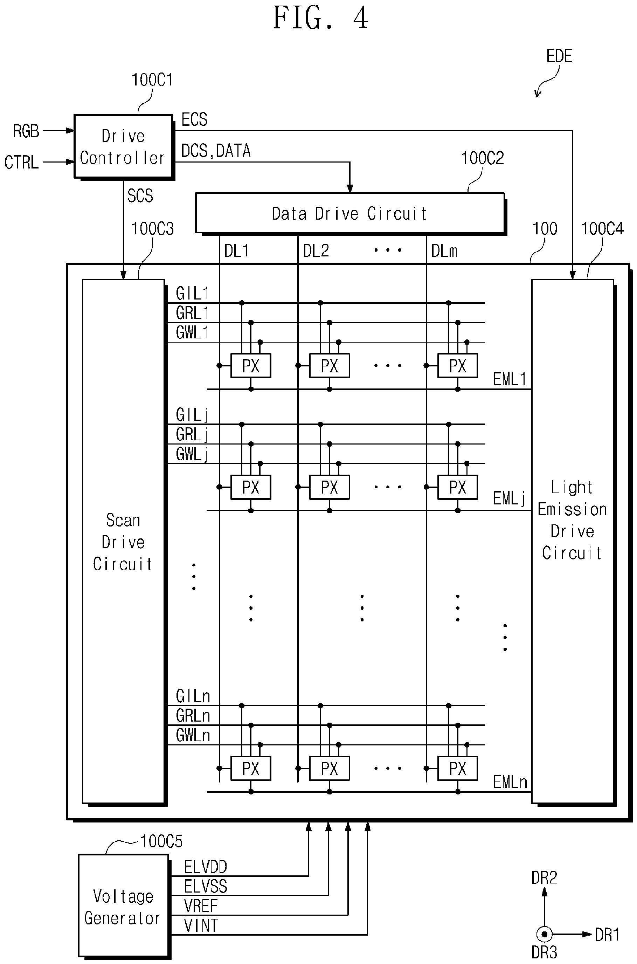

FIG. 4 is a block diagram illustrating some components of the electronic device EDE according to an embodiment.

Referring to FIG. 4, the electronic device EDE may include the display layer 100, a drive controller 100C1, a data drive circuit 100C2, a scan drive circuit 100C3, a light emission drive circuit 100C4, and a voltage generator 100C5.

The display layer 100 may include pixels PX, scan lines GIL1 to GILn, GRL1 to GRLn, and GWL1 to GWLn, light emission control lines EMI,1 to EMI,n, and data lines DL1 to DLm.

The pixels PX may be disposed in an active region 1000A (refer to FIG. 1A) of the display layer 100. Each of the pixels PX may be electrically connected to three scan lines, one light emission control line, and one data line. For example, as illustrated in FIG. 4, the pixels PX in the first row may be connected to the scan lines GIL1, GRL1, and GWL1 and the light emission control line EML1. For example, the pixels PX in the j-th row may be connected to the scan lines GILj, GRLj, and GWLj and the light emission control line ENILj.

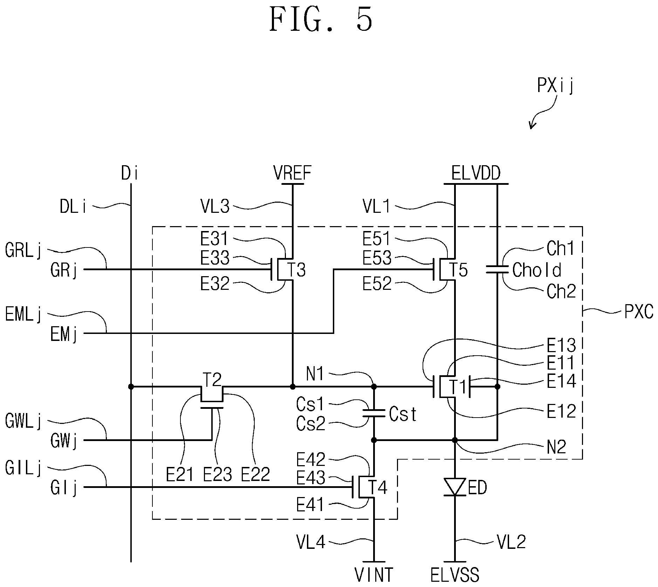

Each of the pixels PX may include a light emitting element ED (refer to FIG. 5) and a pixel circuit PXC (refer to FIG. 5) that controls light emission of the light emitting element ED. The pixel circuit PXC may include one or more transistors and one or more capacitors.

The scan drive circuit 100C3 and the light emission drive circuit 100C4 may be embedded in the display layer 100. Accordingly, the display layer 100 may include the scan drive circuit 100C3 and the light emission drive circuit 100C4. The scan drive circuit 100C3 and the light emission drive circuit 100C4 may include thin film transistors formed by the same process as a process by which the pixel circuit PXC is formed.

In an embodiment, the pixels PX may not overlap the scan drive circuit 100C3 and the light emission drive circuit 100C4. However, embodiments are not limited thereto. For example, at least some of the pixels PX may overlap the scan drive circuit 100C3 and the light emission drive circuit 100C4. For example, at least a portion of the scan drive circuit 100C3 and at least a portion of the light emission drive circuit 100C4 may be disposed in the display region.

The drive controller 100C1 may receive an input image signal RGB and a control signal CTRL. The drive controller 100C1 may generate an output image signal DATA by converting the data format of the input image signal RGB according to the specification of an interface with the data drive circuit 100C2. The drive controller 100C1 may output a scan drive signal SCS, a data drive signal DCS, and a light emission drive signal ECS.

The data drive circuit 100C2 may receive the data drive signal DCS and the output image signal DATA from the drive controller 100C1. The data drive circuit 100C2 may convert the output image signal DATA into data signals and may output the data signals to the data lines DL1 to DLm to be described below. The data signals may be analog voltages corresponding to gray level values of the output image signal DATA.

The scan drive circuit 100C3 may receive the scan drive signal SCS from the drive controller 100C1. The scan drive circuit 100C3 may output scan signals to the scan lines GIL1 to GILn, GRL1 to GRLn, and GWL1 to GWLn in response to the scan drive signal SCS. The scan lines GIL1 to GILn, the scan lines GRL1 to GRLn, and the scan lines GWL1 to GWLn may be referred to as the first initialization scan lines GIL1 to GILn, the compensation scan lines GRL1 to GRLn, and the write scan lines GWL1 to GWLn, respectively.

The light emission drive circuit 100C4 may receive the light emission drive signal ECS from the drive controller 100C1. The light emission drive circuit 100C4 may output light emission control signals to the light emission control lines EML1 to EMI,n in response to the light emission drive signal ECS.

The scan drive circuit 100C3 may be arranged on a first side of the display layer 100. The scan lines GIL1 to GILn, GRL1 to GRLn, and GWL1 to GWLn extend from the scan drive circuit 100C3 in the first direction DR1. The light emission drive circuit 100C4 may be arranged on a second side of the display layer 100. The light emission control lines EML1 to EMLn extend from the light emission drive circuit 100C4 in the direction opposite to the first direction DR1.

Each of the scan lines GIL1 to GILn, GRL1 to GRLn, and GWL1 to GWLn and each of the light emission control lines EML1 to EMI,n may be spaced apart from each other in the second direction DR2. The data lines DL1 to DLm may extend from the data drive circuit 100C2 in the direction opposite to the second direction DR2 and may be spaced apart from each other in the first direction DR1.

In the embodiment illustrated in FIG. 4, the scan drive circuit 100C3 and the light emission drive circuit 100C4 may be arranged to face each other with the pixels PX between the scan drive circuit 100C3 and the light emission drive circuit 100C4. However, embodiments are not limited thereto. For example, the scan drive circuit 100C3 and the light emission drive circuit 100C4 may be disposed on one of the first side and the second side of the display layer 100 so as to be adjacent to each other. In an embodiment, the scan drive circuit 100C3 and the light emission drive circuit 100C4 may be implemented as one circuit (or single circuit).

The voltage generator 100C5 may generate voltages required for an operation of the display layer 100. In the embodiment, the voltage generator 100C5 may generate a first drive voltage ELVDD, a second drive voltage ELVSS, a reference voltage VREF, and an initialization voltage VINT. Each of the pixels PX may receive the first drive voltage ELVDD, the second drive voltage ELVSS, the reference voltage VREF, and the initialization voltage VINT from the voltage generator 100C5.

FIG. 5 is a schematic diagram of an equivalent circuit of a pixel PXij according to an embodiment.

Referring to FIGS. 4 and 5, the equivalent circuit of the pixel PXij connected to the i-th data line DLi among the data lines DL1 to DLm, the j-th scan lines GILj, GRLj, and GWLj among the scan lines GIL1 to GILn, GRL1 to GRLn, and GWL1 to GWLn, and the j-th light emission control line EMLj among the light emission control lines EML1 to EMI,n is illustrated as an example. Each of the pixels PX illustrated in FIG. 4 may have the same configuration as the equivalent circuit diagram of the pixel PXij illustrated in FIG. 5.

The pixel circuit PXC may include first to fifth thin film transistors T1, T2, T3, T4, and T5, a hold capacitor Chold, and a transfer capacitor Cst. The pixel PXij illustrated in FIG. 5 is an example, and various changes and modifications may be made to the circuit configuration of the pixel PXij.

Each of the first to fifth thin film transistors T1 to T5 may be an N-type thin film transistor having an oxide semiconductor layer. The first to fifth thin film transistors T1 to T5 may be referred to as the drive thin film transistor, the switching thin film transistor, the compensation thin film transistor, the initialization thin film transistor, and the light emission control thin film transistor, respectively.

The scan lines GILj, GRLj, and GWLj may transfer scan signals GIj, GRj, and GWj, and the light emission control line EMLj may transfer a light emission control signal EMj. The data line DLi may transfer a data signal Di. The data signal Di may have a voltage level corresponding to the input image signal RGB (refer to FIG. 4).

First to fourth drive voltage lines VL1 to VL4 may transfer the first drive voltage ELVDD, the second drive voltage ELVSS, the reference voltage VREF, and the initialization voltage VINT to the pixel PXij.

The first thin film transistor T1 may include a first electrode E11 electrically connected to the first drive voltage line VL1 via the fifth thin film transistor T5, a second electrode E12 electrically connected to an anode of the light emitting element ED, a first gate electrode E13, and a first back gate electrode E14. A portion where the second electrode E12 of the first thin film transistor T1 and the light emitting element ED are connected may be defined as a second node N2.

The hold capacitor Chold may be connected between the first drive voltage line VL1 and the first back gate electrode E14. A first hold counter electrode Ch1 of the hold capacitor Chold may be connected to the first drive voltage line VL1, and a second hold counter electrode Ch2 of the hold capacitor Chold may be connected to the first back gate electrode E14. In another example, the hold capacitor Chold may be omitted. In another example, the first thin film transistor T1 may not include the first back gate electrode E14.

The second thin film transistor T2 may include a first electrode E21 connected to the data line DLi, a second electrode E22 connected to a first node N1, and a second gate electrode E23 connected to the scan line GWLj. The second thin film transistor T2 may transfer the data signal Di received through the data line DLi to the first node N1 in response to the scan signal GWj received through the scan line GWLj.

The transfer capacitor Cst may be connected between the first node N1 and the second node N2. A first counter electrode Cs1 of the transfer capacitor Cst may be connected to the first node N1, and a second counter electrode Cs2 of the transfer capacitor Cst may be connected to the second node N2.

The third thin film transistor T3 may include a first electrode E31 connected to the third drive voltage line (or the reference voltage line) VL3, a second electrode E32 connected to the first node N1, and a third gate electrode E33 connected to the scan line GRLj. The third thin film transistor T3 may be turned on by the scan signal GRj received through the scan line GRLj and may transfer the reference voltage VREF to the first node N1.

The fourth thin film transistor T4 may include a first electrode E41 connected to the fourth drive voltage line (or the initialization voltage line) VL4, a second electrode E42 connected to the second node N2, and a fourth gate electrode E43 connected to the scan line GILj. The fourth thin film transistor T4 may transfer the initialization voltage VINT received through the fourth drive voltage line VL4 to the second node N2 in response to the scan signal GIj received through the scan line GILj.

The fifth thin film transistor T5 may include a first electrode E51 connected to the first drive voltage line VL1, a second electrode E52 connected to the first electrode E11 of the first thin film transistor T1, and a fifth gate electrode E53 connected to the light emission control line EMLj. The fifth thin film transistor T5 may be turned on by the light emission control signal EMj received through the light emission control line EMLj and may electrically connect the first drive voltage line VL1 to the first electrode E11 of the first thin film transistor T1.

The light emitting element ED may include the anode connected to the second electrode E12 of the first thin film transistor T1 or the second node N2 and a cathode connected to the second drive voltage line VL2.

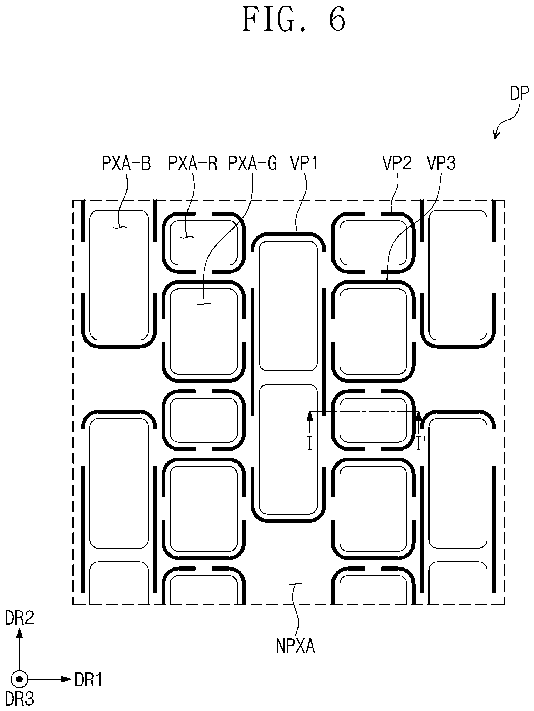

FIG. 6 is a schematic plan view illustrating a portion of the display panel DP according to an embodiment.

Referring to FIG. 6, the active region 1000A (refer to FIG. 1A) of the display panel DP may include emissive regions PXA-B, PXA-R, and PXA-G and a non-emissive region NPXA surrounding the emissive regions PXA-B, PXA-R, and PXA-G. The emissive regions PXA-B, PXA-R, and PXA-G may include the first emissive region PXA-B, the second emissive region PXA-R, and the third emissive region PXA-G. The first emissive region PXA-B, the second emissive region PXA-R, and the third emissive region PXA-G may display light having different wavelengths. The first emissive region PXA-B may display first light that is light having a blue wavelength, the second emissive region PXA-R may display second light that is light having a red wavelength, and the third emissive region PXA-G may display third light that is light having a green wavelength.

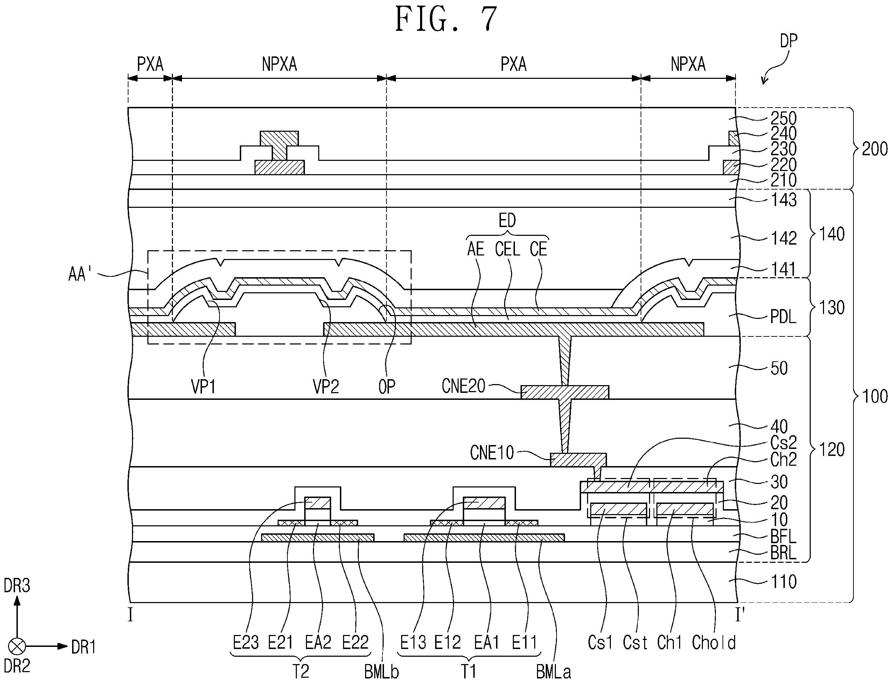

The emissive regions PXA-B, PXA-R, and PXA-G may be regions divided from one another by a pixel defining layer PDL (refer to FIG. 7) that will be described below. The non-emissive region NPXA may be a region between the adjacent emissive regions PXA-B, PXA-R, and PXA-G and may be a region corresponding to the pixel defining layer PDL. The emissive regions PXA-B, PXA-R, and PXA-G may be divided from one another to correspond to openings OP (refer to FIG. 7) that are defined in the pixel defining layer PDL.

The first emissive region PXA-B may form a first pixel group arranged in the second direction DR2, and the second emissive region PXA-R and the third emissive region PXA-G may form a second pixel group alternately arranged in the second direction DR2. The first pixel group formed by the first emissive region PXA-B and the second pixel group formed by the second emissive region PXA-R and the third emissive region PXA-G may be spaced apart from each other in the first direction DR1. The first pixel group and the second pixel group may be alternately arranged in the first direction DR1.

The emissive regions PXA-B, PXA-R, and PXA-G may have different areas according to the wavelengths of light emitted by the emissive regions PXA-B, PXA-R, and PXA-G. For example, as illustrated in FIG. 6, the first emissive region PXA-B emitting the first light may have the largest area, and the second emissive region PXA-R generating the second light may have the smallest area. However, embodiments are not limited thereto, and the emissive regions PXA-B, PXA-R, and PXA-G may have the same area or may be defined at an area ratio different from that illustrated in FIG. 6. The emissive regions PXA-B, PXA-R, and PXA-G may emit other colors of light other than the light having the blue wavelength, the light having the red wavelength, and the light having the green wavelength described above.

Each of the emissive regions PXA-B, PXA-R, and PXA-G may have a rounded rectangular shape in plan view. In an embodiment, each of the first emissive region PXA-B and the third emissive region PXA-G may have a rounded rectangular shape with long sides extending in the second direction DR2 and short sides extending in the first direction DR1. In an embodiment, the second emissive region PXA-R may have a rounded rectangular shape with long sides extending in the first direction DR1 and short sides extending in the second direction DR2. However, the shapes of the emissive regions PXA-B, PXA-R, and PXA-G in plan view are not limited thereto.

In an embodiment, valleys VP1, VP2, and VP3 overlapping the non-emissive region NPXA may be defined in the pixel defining layer PDL (refer to FIG. 7) of the display panel DP (e.g., in the upper surface of pixel defining layer PDL). The valleys VP1, VP2, and VP3 may surround at least portions of the emissive regions PXA-B, PXA-R, and PXA-G, respectively. For example, the valleys VP1, VP2, and VP3 may surround the portions of the emissive regions PXA-B, PXA-R, and PXA-G, respectively, and may not surround the remaining portions of the emissive regions PXA-B, PXA-R, and PXA-G. The valleys VP1, VP2, and VP3 may be referred to as control patterns, valley patterns, concave portions, concave grooves, grooves, or groove patterns.

The valleys VP1, VP2, and VP3 may be defined in the pixel defining layer PDL. On a section, the valleys VP1, VP2, and VP3 may have a shape recessed from the upper surface of the pixel defining layer PDL in the thickness direction of the pixel defining layer PDL. The shape of the valleys VP1, VP2, and VP3 on the section will be described below in detail.

The valleys VP1, VP2, and VP3 may include the first valley VP1 surrounding a portion of the first emissive region PXA-B, the second valley VP2 surrounding a portion of the second emissive region PXA-R, and the third valley VP3 surrounding a portion of the third emissive region PXA-G. The first valley VP1 may surround a portion of the first emissive region PXA-B and may not surround the remaining portion of the first emissive region PXA-B. The second valley VP2 may surround a portion of the second emissive region PXA-R and may not surround the remaining portion of the second emissive region PXA-R. The third valley VP3 may surround a portion of the third emissive region PXA-G and may not surround the remaining portion of the third emissive region PXA-G. However, this is an example, and the first valley VP1, the second valley VP2, and the third valley VP3 may surround the first emissive region PXA-B, the second emissive region PXA-R, and the third emissive region PXA-G, respectively.

In an embodiment, the valleys VP1, VP2, and VP3 may prevent a lateral leakage current from being generated between the adjacent pixels PX (refer to FIG. 4). In the description, the "lateral leakage current" refers to a current flowing in another direction intersecting the third direction DR3 other than a current flowing in the third direction DR3, which is the stacking direction of the light emitting element ED (refer to FIG. 7), e.g., in the direction in which an image is displayed. The lateral leakage current may refer to a current flowing in a direction parallel to a plane defined by the first direction DR1 and the second direction DR2 or a direction similar to the direction. In an embodiment, as the valleys VP1, VP2, and VP3 recessed in the thickness direction of the pixel defining layer PDL are defined, the lateral leakage current may be prevented from being generated, and thus color mixing due to unintended light emission of an adjacent pixel region may be prevented. Accordingly, the color representation accuracy of the display panel DP may be improved.

FIG. 7 is a schematic sectional view of the display panel DP according to an embodiment. For example, FIG. 7 may be a schematic sectional view taken along line I-I' of FIG. 6.

Referring to FIG. 7, the circuit layer 120 may be disposed on the base layer 110. The circuit layer 120 may include a barrier layer BRL, a buffer layer BFL, and first to fifth insulating layers 10, 20, 30, 40, and 50 that are sequentially stacked on the base layer 110, and the pixel circuit PXC (refer to FIG. 5). In FIG. 7, two thin film transistors T1 and T2 and two capacitors Cst and Chold of the pixel circuit PXC are illustrated.

The barrier layer BRL may be disposed on the base layer 110. The barrier layer BRL may have a single-layer structure or a multi-layer structure. The barrier layer BRL may include at least one of silicon oxide, silicon nitride, silicon oxy nitride, and amorphous silicon.

Lower conductive layers BMI,a and BMI,b may be disposed on the barrier layer BRL. However, embodiments are not limited thereto. For example, in the case that the barrier layer BRL has a multi-layer structure, the lower conductive layers BMI,a and BMI,b may be disposed between layers constituting the barrier layer BRL. For example, although FIG. 7 illustrates an example that each of the lower conductive layers BMI,a and BMLb is implemented with one layer (or single layer), each of the lower conductive layers BMI,a and BMI,b may include a plurality of layers.

Each of the lower conductive layers BMI,a and BMI,b may include reflective metal. For example, each of the lower conductive layers BMI,a and BMI,b may include titanium (TI), molybdenum (Mo), an alloy containing molybdenum, aluminium (Al), an alloy containing aluminium, aluminium nitride (AlN), tungsten (W), tungsten nitride (WN), and copper (Cu). The lower conductive layers BMI,a and BMLb may block an influence of an electrical potential due to a polarization phenomenon of the base layer 110 on the thin film transistors T1 and T2. For example, the lower conductive layers BMI,a and BMI,b may block light incident to the thin film transistors T1 and T2 from below.

In an embodiment, the first lower conductive layer BMLa disposed under the first thin film transistor T1 and the second lower conductive layer BMI,b disposed under the second thin film transistor T2 may be electrically isolated from each other. For example, the first lower conductive layer BMI,a disposed under the first thin film transistor T1 may be synchronized with the second electrode E12 of the first thin film transistor T1. The second lower conductive layer BMI,b disposed under the second thin film transistor T2 may be synchronized with the second gate electrode E23 of the second thin film transistor T2. However, this is an example, and embodiments are not limited thereto. For example, the lower conductive layers BMI,a and BMLb may independently receive a constant voltage or a pulse signal. In another example, each of the lower conductive layers BMI,a and BMI,b may be formed in a form isolated from another conductive pattern. Each of the lower conductive layers BMI,a and BMLb according to an embodiment may be formed in various forms and is not limited to any one embodiment.

The buffer layer BFL may be disposed on the barrier layer BRL. The buffer layer BFL may prevent diffusion of metal atoms or impurities from the base layer 110 to a semiconductor pattern. Furthermore, the buffer layer BFL may adjust the speed at which heat is provided during a crystallization process for forming the semiconductor pattern, thereby enabling the semiconductor pattern to be uniformly formed. The buffer layer BFL may include inorganic layers. For example, the buffer layer BFL may include a first sub-buffer layer including silicon nitride and a second sub-buffer layer that is disposed on the first sub-buffer layer and that includes silicon oxide.

A semiconductor pattern layer EA1, E11, E12, EA2, E21, and E22 may be disposed on the buffer layer BFL. The semiconductor pattern layer EA1, E11, E12, EA2, E21, and E22 may include metal oxide. A metal oxide semiconductor may include a crystalline or amorphous oxide semiconductor. For example, the oxide semiconductor may include metal oxide of zinc (Zn), indium (In), gallium (Ga), tin (Sn), or titanium (Ti). In another example, the oxide semiconductor may include a mixture of metal such as zinc (Zn), indium (In), gallium (Ga), tin (Sn), or titanium (Ti) and oxide thereof. The oxide semiconductor may include indium-tin oxide (ITO), indium-gallium-zinc oxide (IGZO), zinc oxide (ZnO), indium-zinc oxide (IZO), zinc-indium oxide (ZIO), indium oxide (InO), titanium oxide (TiO), indium-zinc-tin oxide (IZTO), or zinc-tin oxide (ZTO).

The semiconductor pattern layer EA1, E11, E12, EA2, E21, and E22 may include a plurality of regions distinguished from one another according to whether metal oxide is reduced. A region where metal oxide is reduced (hereinafter, referred to as the reduced region) may have a higher conductivity than a region where metal oxide is not reduced (hereinafter, referred to as the non-reduced region). The reduced region substantially may function as a source/drain of a thin film transistor or a signal line. The non-reduced region may substantially correspond to a semiconductor region (or a channel) of the thin film transistor. For example, a portion of the semiconductor pattern may be the semiconductor region of the thin film transistor, another portion may be the source/drain of the thin film transistor, and yet another portion may be a signal transmission region.

The semiconductor pattern layer EA1, E11, E12, EA2, E21, and E22 may include the first channel region EA1 of the first thin film transistor T1 and the second channel region EA2 of the second thin film transistor T2. The first and second channel regions EA1 and EA2 may be non-reduced regions. Each of the first electrode E11 and the second electrode E12 of the first thin film transistor T1 may be the source region or the drain region of the first thin film transistor T1. Each of the first electrode E21 and the second electrode E22 of the second thin film transistor T2 may be the source region or the drain region of the second thin film transistor T2. The first electrode E11 and the second electrode E12 of the first thin film transistor T1 and the first electrode E21 and the second electrode E22 of the second thin film transistor T2 may be reduced regions.

The first insulating layer 10 may be disposed on the first and second channel regions EA1 and EA2. In an embodiment, the first insulating layer 10 may overlap only a specific conductive pattern. For example, the first insulating layer 10 may be disposed only in a region overlapping a conductive layer disposed (e.g., directly disposed) on the first insulating layer 10. FIG. 7 illustrates an example that the first insulating layer 10 is disposed only in the regions that overlap the first gate electrode E13 of the first thin film transistor T1, the second gate electrode E23 of the second thin film transistor T2, the first counter electrode Cs1 of the transfer capacitor Cst, and the first hold counter electrode Ch1 of the hold capacitor Chold. However, embodiments are not limited thereto. For example, the first insulating layer 10 may overlap (e.g., entirely overlap) the base layer 110.

The second insulating layer 20 may be disposed on the buffer layer BFL and may cover the first insulating layer 10, the first gate electrode E13 of the first thin film transistor T1, the second gate electrode E23 of the second thin film transistor T2, the first counter electrode Cs1 of the transfer capacitor Cst, and the first hold counter electrode Ch1 of the hold capacitor Chold.

Each of the first insulating layer 10 and the second insulating layer 20 may be an inorganic layer and may have a single-layer structure or a multi-layer structure. Each of the first insulating layer 10 and the second insulating layer 20 may include at least one of aluminium oxide, titanium oxide, silicon oxide, silicon nitride, silicon oxy nitride, zirconium oxide, and hafnium oxide. In the embodiment, each of the first insulating layer 10 and the second insulating layer 20 may be a single silicon oxide layer.

The second counter electrode Cs2 of the transfer capacitor Cst and the second hold counter electrode Ch2 of the hold capacitor Chold may be disposed on the second insulating layer 20. The second counter electrode Cs2 and the second hold counter electrode Ch2 may be connected to each other and may form one body (or integrated body).

The third insulating layer 30 may be disposed on the second insulating layer 20 and may cover the second counter electrode Cs2 and the second hold counter electrode Ch2. The third insulating layer 30 may be an inorganic layer and may have a single-layer structure or a multi-layer structure. The third insulating layer 30 may include at least one of aluminium oxide, titanium oxide, silicon oxide, silicon nitride, silicon oxy nitride, zirconium oxide, and hafnium oxide.

A first connecting electrode CNE10 may be disposed on the third insulating layer 30. The first connecting electrode CNE10 may be connected to the second counter electrode Cs2 through a contact hole penetrating the third insulating layer 30.

The fourth insulating layer 40 may be disposed on the third insulating layer 30. The fourth insulating layer 40 may be an organic layer. A second connecting electrode CNE20 may be disposed on the fourth insulating layer 40. The second connecting electrode CNE20 may be connected to the first connecting electrode CNE10 through a contact hole penetrating the fourth insulating layer 40. The fifth insulating layer 50 may be disposed on the fourth insulating layer 40 and may cover the second connecting electrode CNE20. The fifth insulating layer 50 may be an organic layer.

Each of the fourth insulating layer 40 and the fifth insulating layer 50 may include a general purpose polymer, such as benzocyclobutene (BCB), polyimide, hexamethyldisiloxane (HMDSO), Polymethylmethacrylate (PMMA), or Polystyrene (PS), a polymer derivative having a phenolic group, an acrylic polymer, an imide-based polymer, an aryl ether-based polymer, an amide-based polymer, a fluorine-based polymer, a p-xylene-based polymer, a vinyl alcohol-based polymer, or a blend thereof. However, embodiments are not limited thereto.

The element layer 130 may be disposed on the circuit layer 120. The element layer 130 may include the light emitting elements ED. In FIG. 7, a single light emitting element ED is representatively illustrated. An emissive region PXA may be defined to correspond to the light emitting element ED. The emissive region PXA may be defined by the pixel defining layer PDL that will be described below.

The light emitting element ED may include a first electrode AE, an intermediate layer CEL, and a second electrode CE. The first electrode AE may be referred to as the pixel electrode or the anode, and the second electrode CE may be referred to as the common electrode or the cathode. The intermediate layer CEL may include a functional layer commonly provided for the pixels PX (refer to FIG. 4) and an emissive layer patterned to correspond to each of the pixels PX.

The first electrode AE may be disposed on the fifth insulating layer 50. The first electrode AE may be connected to the second connecting electrode CNE20 through a contact hole penetrating the fifth insulating layer 50. The first electrode AE may be a transmissive electrode, a semi-transmissive electrode, or a reflective electrode. In an embodiment, the first electrode AE may include a reflective layer formed of silver, magnesium, aluminium, platinum, palladium, gold, nickel, neodymium, iridium, chromium, or a compound thereof and a transparent or translucent electrode layer formed on the reflective layer. The transparent or translucent electrode layer may include at least one selected from the group consisting of indium tin oxide, indium zinc oxide, indium gallium zinc oxide, zinc oxide, indium oxide and aluminium-doped zinc oxide. For example, the first electrode AE may include a multi-layer structure in which indium tin oxide, silver, and indium tin oxide are sequentially stacked one above another.

The pixel defining layer PDL may be disposed on the fifth insulating layer 50. The pixel defining layer PDL may have a property of absorbing light. For example, the pixel defining layer PDL may be black in color. The pixel defining layer PDL may include a black coloring agent. The black coloring agent may include a black dye or a black pigment. The black coloring agent may include carbon black, metal such as chromium, or oxide thereof. The material of the pixel defining layer PDL is not limited thereto.

The opening OP for exposing a portion of the first electrode AE may be defined in the pixel defining layer PDL. For example, the pixel defining layer PDL may cover the periphery of the first electrode AE. The emissive region PXA may be defined by the pixel defining layer PDL. For example, the valleys VP1 and VP2 overlapping the non-emissive region NPXA may be defined in the pixel defining layer PDL. The valleys VP1 and VP2 may have a shape recessed in the third direction DR3, which is the thickness direction, from the upper surface of the pixel defining layer PDL. The depths of the valleys VP1 and VP2 may be smaller than the maximum thickness of the pixel defining layer PDL. Accordingly, the side surfaces and the bottom surfaces of the valleys VP1 and VP2 may be defined by the pixel defining layer PDL.

In an embodiment, a mask layer may be used to form the valleys VP1 and VP2 in the pixel defining layer PDL. For example, a residue of the mask layer may remain on the first electrode AE. For example, the mask layer may include indium-gallium-zinc oxide (IGZO). A residue of the IGZO may remain on the upper surface of the first electrode AE.

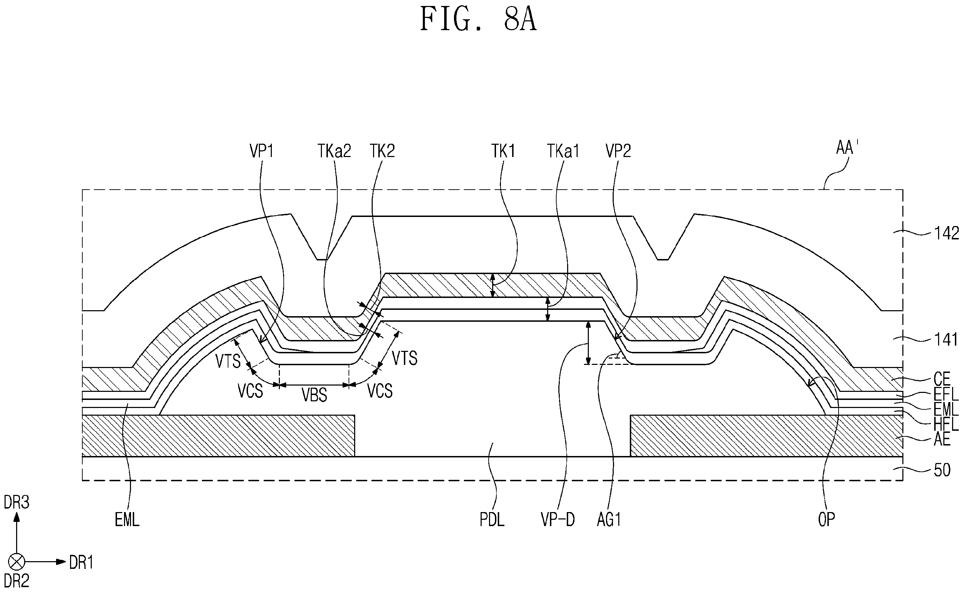

FIG. 8A is an enlarged schematic sectional view illustrating a portion of the display panel DP according to an embodiment. For example, FIG. 8A is an enlarged schematic sectional view illustrating region AA' illustrated in FIG. 7. In FIG. 8A, a portion of the pixel defining layer PDL is illustrated.

Referring to FIGS. 7 and 8A together, each of the valleys VP1 and VP2 may be defined by a valley bottom surface VBS, a valley curved surface VCS, and a valley tapered surface VTS. The valley bottom surface VBS, the valley curved surface VCS, and the valley tapered surface VTS may be defined by the pixel defining layer PDL. The valley curved surface VCS may extend from the valley bottom surface VBS and may have a selectable curvature. For example, the radius of curvature of the valley curved surface VCS may range from about 100 nm to about 230 nm, but embodiments are not limited thereto. The valley tapered surface VTS may extend from the valley curved surface VCS.

As the valley curved surface VCS is defined between the valley bottom surface VBS and the valley tapered surface VTS, the angle of the side surface of the pixel defining layer PDL that defines each of the valleys VP1 and VP2 may be gently changed. Accordingly, a first encapsulation layer 141 to be described below may be stably formed.

Each of the valleys VP1 and VP2 may have a depth VP-D of about 0.45 micrometers or less and a width of about 4 micrometers. However, this is an example, and embodiments are not limited thereto. For example, the depth VP-D and width of each of the valleys VP1 and VP2 may be changed according to the resolution or product design of the display panel DP.

The taper angle AG1 at which the valley tapered surface VTS is inclined with respect to a plane aligned with the valley bottom surface VBS may have a certain angle. The certain angle may range from about 70 degrees to about 80 degrees. In the case that the taper angle AG1 is less than about 70 degrees, the degree of decrease in the thickness of the intermediate layer CEL and the second electrode CE disposed on the pixel defining layer PDL may be small, and therefore an effect of preventing a lateral leakage current may be decreased. In the case that the taper angle AG1 exceeds about 80 degrees, the side surfaces of the valleys VP1 and VP2 may have an inverted taper structure, which causes damage such as cracks in the layer disposed above.

The intermediate layer CEL may be disposed on the first electrode AE and the pixel defining layer PDL. The intermediate layer CEL may include a first functional layer HFL, an emissive layer EML, and a second functional layer EFL.

The first functional layer HFL may include a hole transport layer (HTL), may include a hole injection layer (HIL), or may include both the hole transport layer and the hole injection layer. The first functional layer HFL may be disposed in the entire active region 1000A (refer to FIG. 1A). Accordingly, the first functional layer HFL may be disposed in the opening OP of the pixel defining layer PDL and the valleys VP1 and VP2 of the pixel defining layer PDL.

The emissive layer EML, may be disposed on the first functional layer HFL and may be disposed in a region overlapping the opening OP of the pixel defining layer PDL. The emissive layer EML, may include an organic material, an inorganic material, or an organic-inorganic material that emits light having a certain color. At least a portion of the emissive layer EML may be disposed in at least one of the valleys VP1 and VP2. For example, the emissive layer EML may be disposed in the second valley VP2 adjacent to the opening OP in which the emissive layer EML, is disposed. However, embodiments are not limited thereto. For example, the emissive layer EML, may be disposed not only in the adjacent second valley VP2 but also in the first valley VP1 spaced apart from the opening OP, which overlaps the emissive layer EML, with the second valley VP2 between the first valley VP1 and the opening OP.

The second functional layer EFL may be disposed on the first functional layer HFL and may cover the emissive layer EML. Accordingly, a portion of the second functional layer EFL may be disposed on the emissive layer EML. The second functional layer EFL may include an electron transport layer (ETL), may include an electron injection layer (EIL), or may include both the electron transport layer and the electron injection layer. The second functional layer EFL may be disposed in the entire active region 1000A (refer to FIG. 1A). Accordingly, the second functional layer EFL may be disposed in the opening OP of the pixel defining layer PDL and the valleys VP1 and VP2 of the pixel defining layer PDL.

The second electrode CE may be disposed on the second functional layer EFL. The second electrode CE may be disposed in the entire active region 1000A (refer to FIG. 1A). Accordingly, the second electrode CE may be disposed in the opening OP of the pixel defining layer PDL and the valleys VP1 and VP2 of the pixel defining layer PDL.

In an embodiment, the thickness of the intermediate layer CEL and the thickness of the second electrode CE may be decreased by the valleys VP1 and VP2. The thickness TK2 of the second electrode CE facing the valley tapered surface VTS may be smaller than the thickness TK1 of the second electrode CE disposed on the flat upper surface of the pixel defining layer PDL. For example, the thickness TKa2 of the intermediate layer CEL facing the valley tapered surface VTS may be less than the thickness TKa1 of the intermediate layer CEL disposed on the flat upper surface of the pixel defining layer PDL. In an embodiment, a portion of the intermediate layer CEL may be cut off at portions overlapping the valleys VP1 and VP2.

As the thicknesses of the intermediate layer CEL and the second electrode CE are decreased, the resistances of the intermediate layer CEL and the second electrode CE may be increased in the portions overlapping the valleys VP1 and VP2. Accordingly, a current may be prevented from being leaked into the portions where the valleys VP1 and VP2 are formed.

Referring again to FIG. 7, the encapsulation layer 140 may be disposed on the element layer 130. The encapsulation layer 140 may include an organic layer and a plurality of inorganic layers sealing the organic layer. For example, the encapsulation layer 140 may include the first encapsulation layer 141, a second encapsulation layer 142, and a third encapsulation layer 143 sequentially stacked one above another, but embodiments are not limited thereto. The first and third encapsulation layers 141 and 143 may protect the element layer 130 from moisture and oxygen, and the second encapsulation layer 142 may protect the element layer 130 from foreign matter such as dust particles. For example, the first and third encapsulation layers 141 and 143 may be inorganic encapsulation layers, and the second encapsulation layer 142 may be an organic encapsulation layer.

The sensor layer 200 may be disposed on the display layer 100. The sensor layer 200 may be referred to as the sensor, the input sensing layer, or the input sensing panel. The sensor layer 200 may have a function of sensing an external input. For example, the sensor layer 200 may sense at least one of an active input by an input device and a passive input by a touch.

The sensor layer 200 may include a sensor base layer 210, a first sensor conductive layer 220, a sensor insulating layer 230, a second sensor conductive layer 240, and a sensor cover layer 250.

The sensor base layer 210 may be disposed (e.g., directly disposed) on the display layer 100. The sensor base layer 210 may be an inorganic layer including at least one of silicon nitride, silicon oxy nitride, and silicon oxide. In another example, the sensor base layer 210 may be an organic layer including an epoxy resin, an acrylic resin, or an imide-based resin. The sensor base layer 210 may have a single-layer structure, or may have a multi-layer structure stacked in the third direction DR3.

Each of the first sensor conductive layer 220 and the second sensor conductive layer 240 may have a single-layer structure, or may have a multi-layer structure stacked in the third direction DR3.

A conductive layer having a single-layer structure may include a metal layer or a transparent conductive layer. The metal layer may include molybdenum, silver, titanium, copper, aluminium, or an alloy thereof. The transparent conductive layer may include transparent conductive oxide such as indium tin oxide, indium zinc oxide, zinc oxide, or indium zinc tin oxide. For example, the transparent conductive layer may include a conductive polymer such as poly(3,4-ethylenedioxythiophene) (PEDOT), a metal nano-wire, or graphene.

A conductive layer having a multi-layer structure may include metal layers. The metal layers may have, for example, a three-layer structure of titanium/aluminium/titanium. The conductive layer having the multi-layer structure may include at least one metal layer and at least one transparent conductive layer.

The sensor insulating layer 230 may be disposed between the first sensor conductive layer 220 and the second sensor conductive layer 240. The sensor cover layer 250 may be disposed on the sensor insulating layer 230 and may cover the second sensor conductive layer 240. The second sensor conductive layer 240 may include a conductive pattern. The sensor cover layer 250 may cover the conductive pattern and may reduce or eliminate a probability of damage to the conductive pattern in a subsequent process.

Each of the sensor insulating layer 230 and the sensor cover layer 250 may include an inorganic film. The inorganic film may include at least one of aluminium oxide, titanium oxide, silicon oxide, silicon nitride, silicon oxy nitride, zirconium oxide, and hafnium oxide.

In another example, each of the sensor insulating layer 230 and the sensor cover layer 250 may include an organic film. The organic film may include at least one of an acrylic resin, a methacrylic resin, a polyisoprene resin, a vinyl resin, an epoxy resin, a urethane-based resin, a celluosic resin, a siloxane-based resin, a polyimide resin, a polyamide resin, and a perylene-based resin.

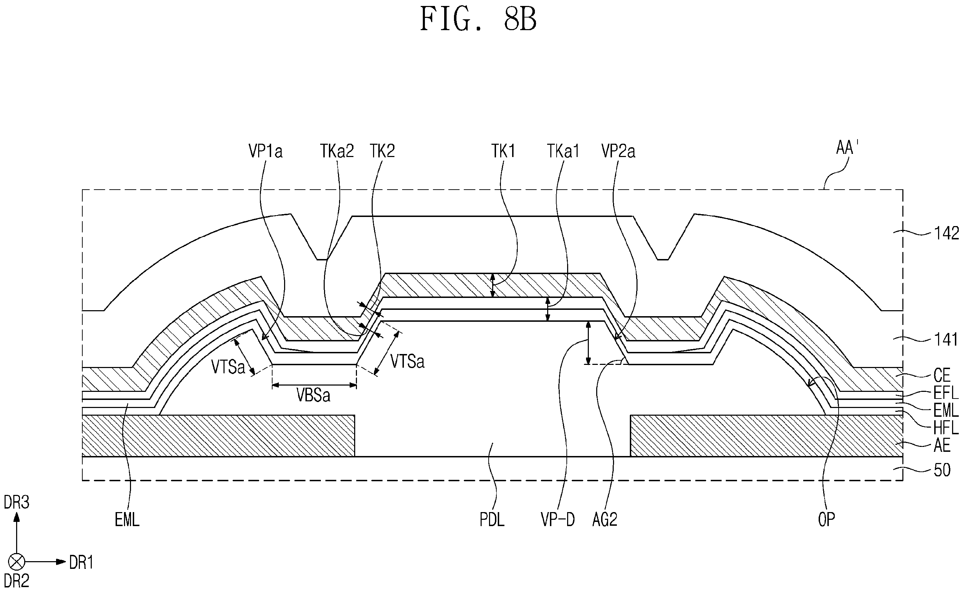

FIG. 8B is an enlarged schematic sectional view illustrating a portion of the display panel DP (refer to FIG. 1A) according to an embodiment. FIG. 8B is a schematic sectional view of region AA' illustrated in FIG. 7 according to an embodiment.

Referring to FIGS. 7 and 8B, valleys VP1a and VP2a overlapping the non-emissive region NPXA may be defined in the pixel defining layer PDL. Each of the valleys VP1a and VP2a may be defined by a valley bottom surface VBSa and a valley tapered surface VTSa. The valley bottom surface VBSa and the valley tapered surface VTSa may be connected to each other.

The taper angle AG2 at which the valley tapered surface VTSa is inclined with respect to a plane aligned with the valley bottom surface VBSa may have a certain angle. The certain angle may range from about 70 degrees to about 80 degrees.

In an embodiment, the thickness of the intermediate layer CEL and the thickness of the second electrode CE may be decreased by the valleys VP1a and VP2a. A portion of the intermediate layer CEL may be cut off at portions overlapping the valleys VP1a and VP2a. As the thicknesses of the intermediate layer CEL and the second electrode CE are decreased, the resistances of the intermediate layer CEL and the second electrode CE may be increased in the portions overlapping the valleys VP1a and VP2a. Accordingly, a current may be prevented from being leaked into the portions where the valleys VP1a and VP2a are formed.

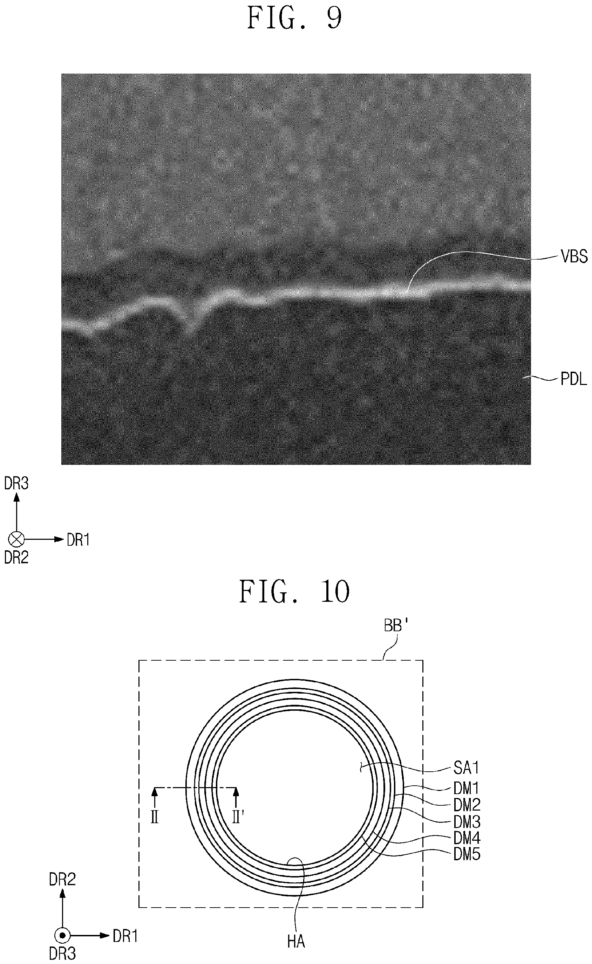

FIG. 9 is an image of a portion of the display panel DP (refer to FIG. 1A) according to an embodiment. The image illustrated in FIG. 9 is an image of the portion of the pixel defining layer PDL where the valley bottom surface VBS is defined.

Referring to FIGS. 7 and 9, the pixel defining layer PDL may include a black coloring agent. The black coloring agent may include carbon black, metal such as chromium, or oxide thereof. For example, in the case that the pixel defining layer PDL is etched to form the valleys VP1 and VP2, an uneven surface may be formed by the black coloring agent.

FIG. 10 is an enlarged schematic plan view illustrating a portion of the display panel DP (refer to FIG. 1A) according to an embodiment. FIG. 10 is an enlarged schematic sectional view illustrating region BB' illustrated in FIG. 1A.

Referring to FIGS. 1A, 7, and 10, a hole HA may be defined in the display panel DP. The hole HA may be defined by removing a portion of the display panel DP. The active region 1000A of the display panel DP may surround the hole HA. The hole HA may overlap or correspond to the sensor region SA1. Although the hole HA is illustrated in a circular shape in the embodiment, the hole HA may have various shapes, such as a polygonal shape, an oval shape, a shape having at least one curved side, or an irregular shape, and is not limited to any one embodiment.

The hole HA may be formed after both the display layer 100 (refer to FIG. 3) and the sensor layer 200 (refer to FIG. 3) are formed. In another example, the hole HA may be formed after the display layer 100 is formed. For example, a process of forming the hole HA may include a process of applying a laser to the rear surface of the base layer 110 (refer to FIG. 3) and a process of providing an etchant toward the rear surface of the base layer 110. The process of applying the laser may be a process of sketching, on the base layer 110, a region to be removed. The etchant may be provided in a direction from the rear surface to the upper surface of the base layer 110 along the third direction DR3.

The display panel DP may further include dams DM1, DM2, DM3, DM4, and DM5 adjacent to the hole HA. The dams DM1, DM2, DM3, DM4, and DM5 may control a flow of monomer during a process of forming the second encapsulation layer 142 or to protect the element layer 130 during a process of forming the hole HA. Although the five dams DM1, DM2, DM3, DM4, and DM5 are illustrated as an example in FIG. 10, embodiments are not limited thereto. Some of the five dams DM1, DM2, DM3, DM4, and DM5 may be omitted, and more dams may be disposed.

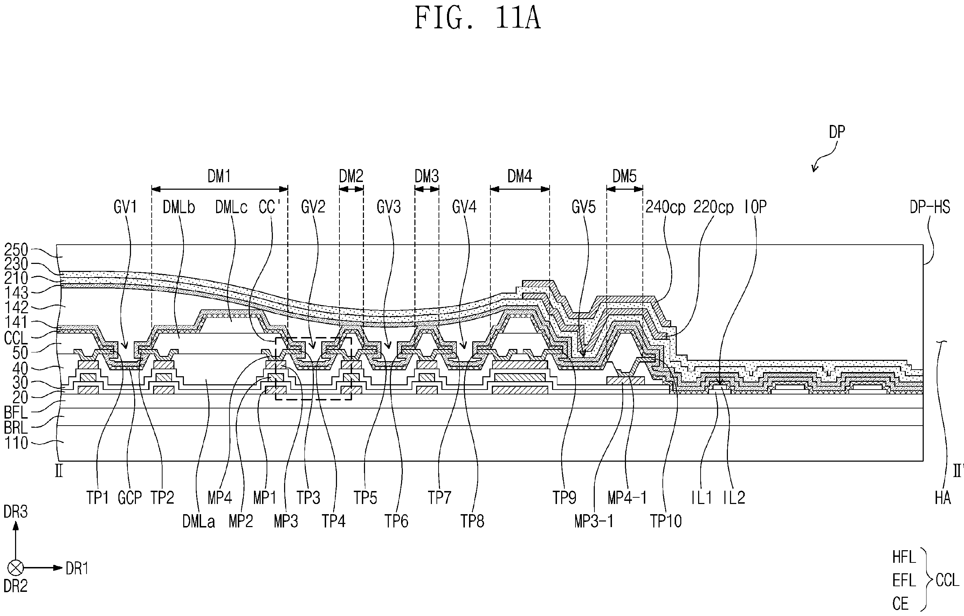

FIG. 11A is a schematic sectional view of the display panel DP according to an embodiment. For example, FIG. 11A may be a schematic sectional view taken along line II-II' of FIG. 10.

Referring to FIGS. 7 and 11A, the display panel DP may include a sidewall DP-HS that defines the hole HA. The display panel DP may include the dams DM1, DM2, DM3, DM4, and DM5 and inorganic dams IOP adjacent to the hole HA. Although the five dams DM1, DM2, DM3, DM4, and DM5 and three inorganic dams IOP are illustrated as an example in FIG. 11A, embodiments are not limited thereto. Some of the five dams DM1, DM2, DM3, DM4, and DM5 and the three inorganic dams IOP may be omitted, and more dams may be disposed.

The dams DM1, DM2, DM3, DM4, and DM5 may include the first dam DM1, the second dam DM2, the third dam DM3, the fourth dam DM4, and the fifth dam DM5. The first to fourth dams DM1, DM2, DM3, and DM4 may control the flow of the monomer during the process of forming the second encapsulation layer 142. The fifth dam DM5 and the inorganic dams IOP may prevent propagation of a crack progressing from the sidewall DP-HS. Accordingly, the fifth dam DM5 may be referred to as the crack dam. The inorganic dams IOP may be referred to as the inorganic patterns.

Among the first to fifth dams DM1, DM2, DM3, DM4, and DM5, the first dam DM1 and the fourth dam DM4 may have the greatest height (or thickness). For example, each of the first dam DM1 and the fourth dam DM4 may include a first conductive layer MP1, the second insulating layer 20, a second conductive layer MP2, the third insulating layer 30, a third conductive layer MP3, a first dam layer DMI,a, a fourth conductive layer MP4, a second dam layer DMI,b, and a third dam layer DMI,c.

The first conductive layer MP1, the first gate electrode E13 of the first thin film transistor T1, the second gate electrode E23 of the second thin film transistor T2, the first counter electrode Cs1 of the transfer capacitor Cst, and the first hold counter electrode Ch1 of the hold capacitor Chold may be disposed on the same layer. The first conductive layer MP1, the first gate electrode E13 of the first thin film transistor T1, the second gate electrode E23 of the second thin film transistor T2, the first counter electrode Cs1 of the transfer capacitor Cst, and the first hold counter electrode Ch1 of the hold capacitor Chold may include the same material.

The second conductive layer MP2, the second counter electrode Cs2 of the transfer capacitor Cst and the second hold counter electrode Ch2 of the hold capacitor Chold may be disposed on the same layer. The second conductive layer MP2, the second counter electrode Cs2 of the transfer capacitor Cst and the second hold counter electrode Ch2 of the hold capacitor Chold may include the same material.

The third conductive layer MP3 and the first connecting electrode CNE10 may be disposed on the same layer and may include the same material. The fourth conductive layer MP4, and the second connecting electrode CNE20 may include the same material as the second connecting electrode CNE20 may be disposed on the same layer.

The first dam layer DMI,a and the fourth insulating layer 40 may include the same material. The first dam layer DMI,a may be a portion of the fourth insulating layer 40. The second dam layer DMLb and the fifth insulating layer 50 may include the same material. The second dam layer DMLb may be a portion of the fifth insulating layer 50. The third dam layer DMLc and the pixel defining layer PDL may be disposed on the same layer and may include the same material.

The second dam DM2 and the third dam DM3 may have a smaller height or thickness than the first and fourth dams DM1 and DM4. For example, each of the second dam DM2 and the third dam DM3 may include a first conductive layer MP1, the second insulating layer 20, a second conductive layer MP2, the third insulating layer 30, a third conductive layer MP3, a first dam layer DMLa, a fourth conductive layer MP4, and a second dam layer DMLb.

In an embodiment, the fourth conductive layer MP4 of each of the first to fourth dams DM1, DM2, DM3, and DM4 may be brought into contact with the third conductive layer MP3. For example, the continuity of the fourth insulating layer 40 may be broken by the third conductive layer MP3 and the fourth conductive layer MP4 brought into contact with each other. Accordingly, a path along which the etchant is able to infiltrate in the case that the hole HA is processed may be shielded by the first to fourth dams DM1, DM2, DM3, and DM4.

Among the first to fifth dams DM1, DM2, DM3, DM4, and DM5, the fifth dam DM5 may be disposed closest to the hole HA. The fifth dam DM5 may include the second insulating layer 20, the third insulating layer 30, a third conductive layer MP3-1, a first dam layer DMI,a, a fourth conductive layer MP4-1, and a second dam layer DMLb.

In an embodiment, the fourth conductive layer MP4-1 of the fifth dam DM5 may be brought into contact with the third conductive layer MP3-1. For example, the continuity of the fourth insulating layer 40 may be broken (or discontinued) by the third conductive layer MP3-1 and the fourth conductive layer MP4-1 brought into contact with each other. Accordingly, a path along which the etchant is able to infiltrate in the case that the hole HA is processed may be additionally shielded by the fifth dam DM5. Accordingly, the reliability of the display panel DP may be further improved.

In an embodiment, each of the inorganic dams IOP may include a first dam layer IL1 and a second dam layer IL2. The first dam layer IL1 and the second insulating layer 20 may include the same material and may be formed by the same process. The second dam layer IL2 and the third insulating layer 30 may include the same material and may be formed by the same process. However, this is an example, and the configuration of layers constituting each of the inorganic dams IOP may be modified in various ways. The width of the first dam layer IL1 may be greater than the width of the second dam layer IL2. Accordingly, each of the inorganic dams IOP may have a step shape.

First to fifth grooves GV1, GV2, GV3, GV4, and GV5 may be defined adjacent to the first to fifth dams DM1, DM2, DM3, DM4, and DM5. The first groove GV1 and the second groove GV2 may be spaced apart from each other with the first dam DM1 between first groove GV1 and the second groove GV2. The second groove GV2 and the third groove GV3 may be spaced apart from each other with the second dam DM2 between the second groove GV2 and the third groove GV3. The third groove GV3 and the fourth groove GV4 may be spaced apart from each other with the third dam DM3 between the third groove GV3 and the fourth groove GV4. The fourth groove GV4 and the fifth groove GV5 may be spaced apart from each other with the fourth dam DM4 between the fourth groove GV4 and the fifth groove GV5.

In an embodiment, the first to fifth grooves GV1, GV2, GV3, GV4, and GV5 may be formed by the same process as the process of forming the valleys VP1, VP2, and VP3 (refer to FIG. 6). Accordingly, an additional process for forming the first to fifth grooves GV1, GV2, GV3, GV4, and GV5 may be omitted. For example, the number of masks used during the process of forming the display panel DP may be decreased, and the manufacturing cost of the display panel DP may be reduced.

In an embodiment, the first to fifth grooves GV1, GV2, GV3, GV4, and GV5 may be formed by the same process as the valleys VP1, VP2, and VP3. Accordingly, the depths of the first to fifth grooves GV1, GV2, GV3, GV4, and GV5 may be determined according to the depths of the valleys VP1, VP2, and VP3. For example, the bottom surfaces of the first to fifth grooves GV1, GV2, GV3, GV4, and GV5 may be defined in the fourth insulating layer 40.

Since the depths of the first to fifth grooves GV1, GV2, GV3, GV4, and GV5 are not controlled by a separate process, but are determined according to the depths of the valleys VP1, VP2, and VP3, the depths of the first to fifth grooves GV1, GV2, GV3, GV4, and GV5 may be less than the maximum thickness of the fourth insulating layer 40. To compensate for this, each of the first to fourth dams DM1, DM2, DM3, and DM4 may have a double wing structure including tip portions protruding in opposite directions. As many as possible of the tip portions may be provided, and thus a common layer CCL may be stably disconnected. Accordingly, the reliability of the display panel DP may be further improved.

For example, each of the first to fourth dams DM1, DM2, DM3, and DM4 may be disposed between the first to fifth grooves GV1, GV2, GV3, GV4, and GV5. The number of tip portions may be twice or more the number of first to fourth dams DM1, DM2, DM3, and DM4. Accordingly, the number of tip portions may be 8 or more.

In an embodiment, the display panel DP may include tip portions TP1, TP2, TP3, TP4, TP5, TP6, TP7, TP8, TP9, and TP10. The first to fifth grooves GV1, GV2, GV3, GV4, and GV5 may be provided to form at least some of the tip portions TP1, TP2, TP3, TP4, TP5, TP6, TP7, TP8, TP9, and TP10. Accordingly, the shapes of the tip portions TP1, TP2, TP3, TP4, TP5, TP6, TP7, TP8, TP9, and TP10 in plan view may be similar to the shapes of the first to fifth grooves GV1, GV2, GV3, GV4, and GV5 in plan view. Each of the tip portions TP1, TP2, TP3, TP4, TP5, TP6, TP7, TP8, TP9, and TP10 may have a shape surrounding the hole HA (refer to FIG. 10). For example, a third tip portion TP3 may have a shape surrounding the hole HA, and a second tip portion TP2 may have a shape surrounding the third tip portion TP3.

The tip portions TP1, TP2, TP3, TP4, TP5, TP6, TP7, TP8, TP9, and TP10 may disconnect the common layer CCL formed with an open mask. For example, the common layer CCL may include the first functional layer HFL, the second functional layer EFL, and the second electrode CE. Portions of the common layer CCL disconnected by the tip portions TP1, TP2, TP3, TP4, TP5, TP6, TP7, TP8, TP9, and TP10, for example, disconnected layers GCP may overlap the first to fifth grooves GV1, GV2, GV3, GV4, and GV5.

The first tip portion TP1 and the second tip portion TP2 may overlap the first groove GV1. The third tip portion TP3 and the fourth tip portion TP4 may overlap the second groove GV2. The fifth tip portion TP5 and the sixth tip portion TP6 may overlap the third groove GV3. The seventh tip portion TP7 and the eighth tip portion TP8 may overlap the fourth groove GV4. The ninth tip portion TP9 may overlap the fifth groove GV5. The tenth tip portion TP10 may protrude from the fifth dam DM5 in a direction toward the hole HA.

The first encapsulation layer 141 may cover all of the first to fifth grooves GV1, GV2, GV3, GV4, and GV5. The second encapsulation layer 142 may be disposed on the first encapsulation layer 141 and may overlap at least some of the first to fifth grooves GV1, GV2, GV3, GV4, and GV5. For example, the second encapsulation layer 142 may overlap the first to fourth grooves GV1, GV2, GV3, and GV4. The third encapsulation layer 143 may be disposed on the second encapsulation layer 142 and may cover all of the first to fifth grooves GV1, GV2, GV3, GV4, and GV5.

In an embodiment, the first sensor conductive layer 220 of the sensor layer 200 may include a first clad pattern 220cp, and the second sensor conductive layer 240 of the sensor layer 200 may include a second clad pattern 240cp. Each of the first clad pattern 220cp and the second clad pattern 240cp may overlap the remaining groove not overlapping the second encapsulation layer 142, for example, the fifth groove GV5. For example, each of the first clad pattern 220cp and the second clad pattern 240cp may overlap the fifth dam DM5 (referred to as the crack dam) and the tenth tip portion TP10 protruding from the fifth dam DM5 toward the hole HA.

The flexure of the third encapsulation layer 143 may be increased by the fifth groove GV5 in which the second encapsulation layer 142 is not disposed. For example, the film quality of the third encapsulation layer 143 may be deteriorated due to the flexure, and therefore the third encapsulation layer 143 may be cracked. In another example, the third encapsulation layer 143 may be oxidized even though the third encapsulation layer 143 includes silicon nitride.

According to an embodiment, the first and second clad patterns 220cp and 240cp may be disposed in a region overlapping the fifth groove GV5. Accordingly, even though the third encapsulation layer 143 is cracked or oxidized, moisture and oxygen may be blocked by the first and second clad patterns 220cp and 240cp. Accordingly, the product reliability of the display panel DP may be improved.

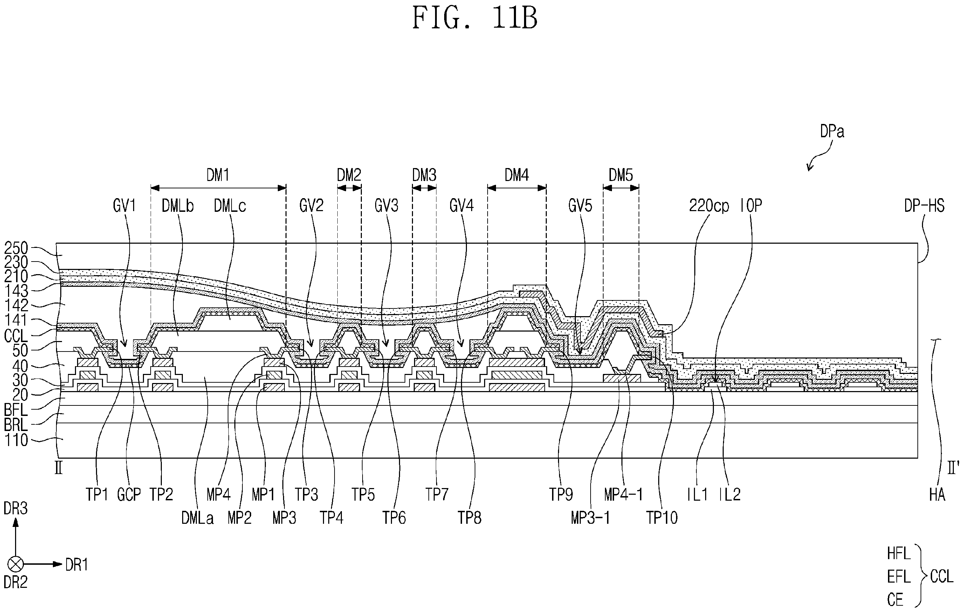

FIG. 11B is a schematic sectional view of a display panel DPa according to an embodiment. In describing FIG. 11B, components identical to the components described with reference to FIG. 11A will be assigned with identical reference numerals, and descriptions thereabout will be omitted for descriptive convenience.

Referring to FIGS. 7 and 11B, a first sensor conductive layer 220 of a sensor layer 200 may include a first clad pattern 220cp. The first clad pattern 220cp may overlap the remaining groove not overlapping a second encapsulation layer 142, for example, a fifth groove GV5. For example, the first clad pattern 220cp may overlap a fifth dam DM5 (referred to as the crack dam) and a tenth tip portion TP10 protruding from the fifth dam DM5 toward a hole HA. Accordingly, even though a third encapsulation layer 143 is cracked or oxidized, moisture and oxygen may be blocked by the first clad pattern 220cp. Accordingly, the product reliability of the display panel DPa may be improved.

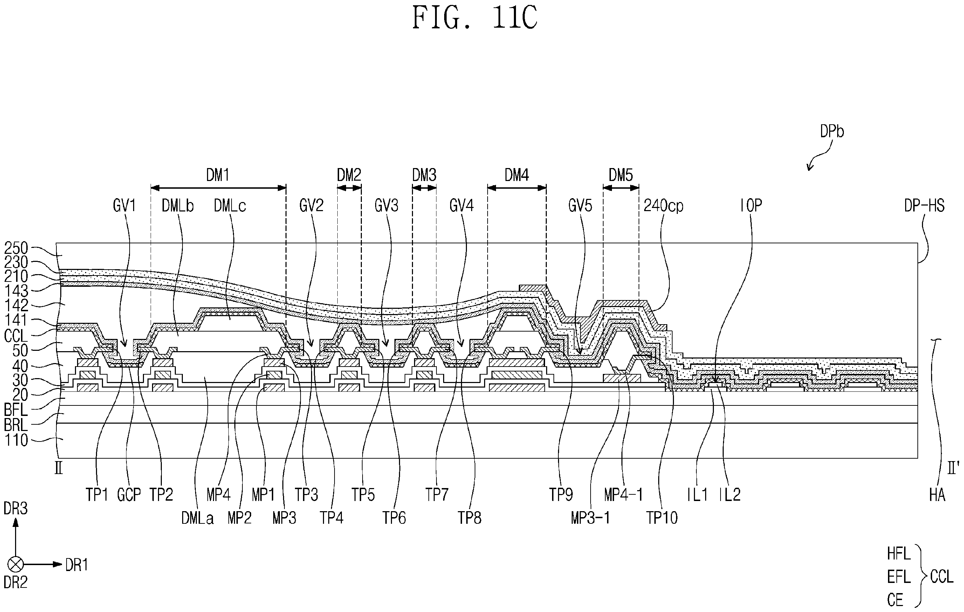

FIG. 11C is a schematic sectional view of a display panel DPb according to an embodiment. In describing FIG. 11C, components identical to the components described with reference to FIG. 11A will be assigned with identical reference numerals, and descriptions thereabout will be omitted for descriptive convenience.

Referring to FIGS. 7 and 11C, a second sensor conductive layer 240 of a sensor layer 200 may include a second clad pattern 240cp. The second clad pattern 240cp may overlap the remaining groove not overlapping a second encapsulation layer 142, for example, a fifth groove GV5. For example, the second clad pattern 240cp may overlap a fifth dam DM5 (referred to as the crack dam) and a tenth tip portion TP10 protruding from the fifth dam DM5 toward a hole HA. Accordingly, even though a third encapsulation layer 143 is cracked or oxidized, moisture and oxygen may be blocked by the second clad pattern 240cp. Accordingly, the product reliability of the display panel DPb may be improved.

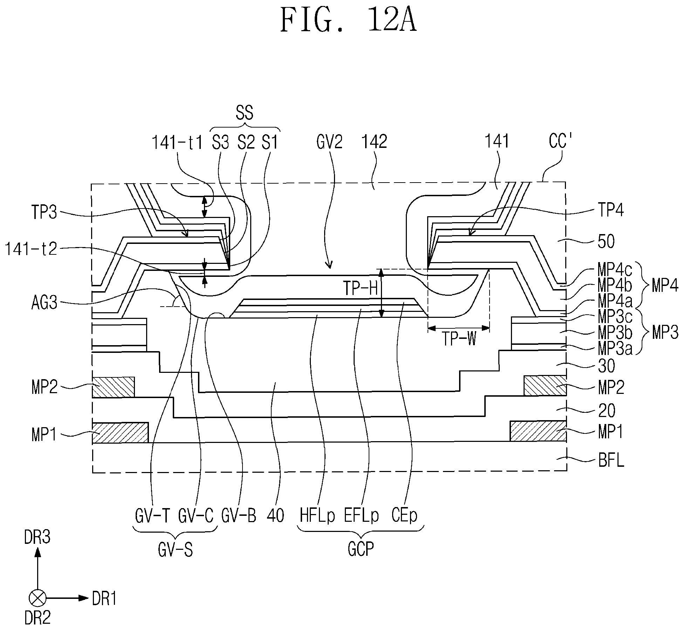

FIG. 12A is a schematic sectional view of the display panel DP (refer to FIG. 11A) according to an embodiment. FIG. 12A is an enlarged schematic sectional view illustrating region CC' illustrated in FIG. 11A. For example, FIG. 12A is an enlarged schematic sectional view illustrating the region where the second groove GV2 is defined. The following description may be identically applied to the first groove GV1, the third groove GV3, and the fourth groove GV4.

Referring to FIGS. 8A, 11A, and 12A, each of the third conductive layer MP3 and the fourth conductive layer MP4 may have a multi-layer structure. For example, each of the third conductive layer MP3 and the fourth conductive layer MP4 may have a three-layer structure of titanium (Ti)/aluminium (Al)/titanium (Ti).

The third conductive layer MP3 may include a first sub-conductive layer MP3a, a second sub-conductive layer MP3b, and a third sub-conductive layer MP3c. The fourth conductive layer MP4 may include a first sub-conductive layer MP4a, a second sub-conductive layer MP4b, and a third sub-conductive layer MP4c. The first sub-conductive layer MP3a, the third sub-conductive layer MP3c, the first sub-conductive layer MP4a, and the third sub-conductive layer MP4c may include titanium, and the second sub-conductive layer MP3b and the second sub-conductive layer MP4b may include aluminium. However, embodiments are not limited thereto.

In an embodiment, a first side surface S 1 of the first sub-conductive layer MP4a, a second side surface S2 of the second sub-conductive layer MP4b, and a third side surface S3 of the third sub-conductive layer MP4c that define a side surface SS of each of the third tip portion TP3 and the fourth tip portion TP4 may be aligned with one another.

The shape of the first to third side surfaces S1, S2, and S3 may vary according to components of an etchant used in a process of forming the first electrode AE, e.g., a process of making the first electrode AE subject to patterning or the materials of the first sub-conductive layer MP4a, the second sub-conductive layer MP4b, and the third sub-conductive layer MP4c. For example, the etchant may include a non-phosphoric acid-based etching composition. For example, the first to third side surfaces S1, S2, and S3 may have an aligned shape.

In an embodiment, a bottom surface GV-B of the second groove GV2 and side surfaces GV-S connected to the bottom surface GV-B may be defined by a single insulating layer, for example, the fourth insulating layer 40. The fourth insulating layer 40 may be an organic insulating layer. The second groove GV2 and the valleys VP1 and VP2 may be formed by the same process. Accordingly, the shape of the second groove GV2 may be similar to the shapes of the valleys VP1 and VP2. The side surfaces GV-S of the second groove GV2 may include a curved surface GV-C extending from the bottom surface GV-B and a tapered surface GV-T extending from the curved surface GV-C. For example, the radius of curvature of the curved surface GV-C may range from about 100 nm to about 230 nm, but embodiments are not limited thereto.

The taper angle AG1 at which the valley tapered surface VTS is inclined with respect to the plane aligned with the valley bottom surface VBS may be substantially the same as the angle AG3 of the tapered surface GV-T with respect to a plane aligned with the bottom surface GV-B. For example, the angle AG3 of the tapered surface GV-T may range from about 70 degrees to about 80 degrees, but embodiments are not limited thereto.

In an embodiment, the depths of the first to fifth grooves GV1, GV2, GV3, GV4, and GV5 may be determined according to the depths VP-D of the valleys VP1 and VP2. For example, the depths VP-D of the valleys VP1 and VP2 may be substantially the same as the height TP-H of the fourth tip portion TP4, which is measured from the bottom surface GV-B of the second groove GV2 to a bottom surface of the fourth tip portion TP4.

In an embodiment, a difference between the width TP-W and the height TP-H of the fourth tip portion TP4 may be less than about 0.15 micrometers and, for example, may be about 0.05 micrometers. The width TP-W of the fourth tip portion TP4 may correspond to the width of the exposed lower surface of the fourth conductive layer MP4. For example, the width TP-W of the fourth tip portion TP4 may be about 0.4 micrometers or less, and the height TP-H of the fourth tip portion TP4 may be about 0.45 micrometers or less. For example, the width TP-W of the fourth tip portion TP4 may be about 0.4 micrometers, and the height TP-H of the fourth tip portion TP4 may be about 0.45 micrometers. However, this is an example, and embodiments are not limited thereto.

The common layer CCL may be formed on the fourth insulating layer 40 in which the second groove GV2 is defined, the third tip portion TP3, the fourth tip portion TP4, and the fifth insulating layer 50. The common layer CCL may be disconnected by the third tip portion TP3 and the fourth tip portion TP4. Accordingly, the disconnected layers GCP may be disposed in the second groove GV2. The disconnected layers GCP may include a first disconnected layer HFLp, a second disconnected layer EFLp, and a third disconnected layer CEp. The first disconnected layer HFLp and the first functional layer HFL may include the same material. The second disconnected layer EFLp and the second functional layer EFL may include the same material. The third disconnected layer CEp and the second electrode CE may include the same material.

The first encapsulation layer 141 may be disposed on the common layer CCL. The first encapsulation layer 141 may be formed by a deposition process, for example, a chemical vapor deposition (CVD) process. In an embodiment, the first encapsulation layer 141 may be formed to correspond to the shapes of the third tip portion TP3 and the fourth tip portion TP4. For example, the thickness 141-t2 of a portion of the first encapsulation layer 141 disposed under the third tip portion TP3 and the fourth tip portion TP4 may be less than the thickness 141-t1 of a portion of the first encapsulation layer 141 disposed on the third tip portion TP3 and the fourth tip portion TP4.

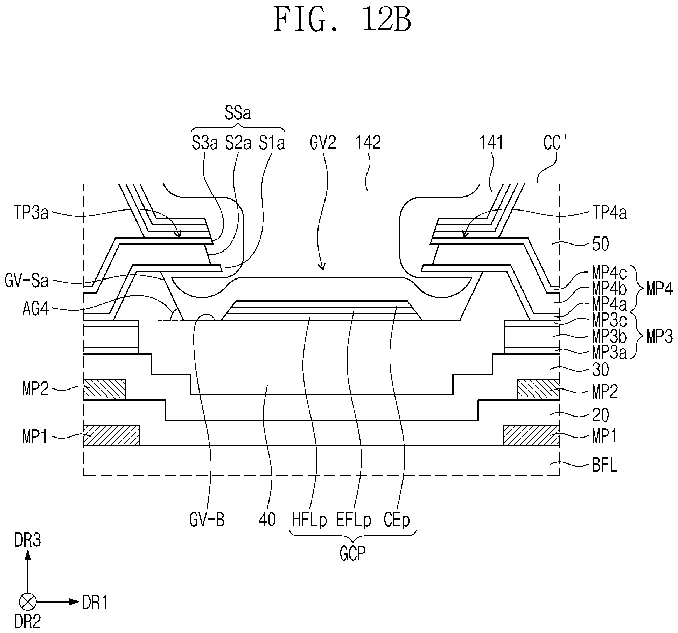

FIG. 12B is a schematic sectional view of the display panel DP (refer to FIG. 11A) according to an embodiment.

Referring to FIGS. 8B and 12B, the fourth conductive layer MP4 may have a multi-layer structure. For example, the fourth conductive layer MP4 may include a first sub-conductive layer MP4a, a second sub-conductive layer MP4b, and a third sub-conductive layer MP4c.

In an embodiment, a first side surface S1a of the first sub-conductive layer MP4a, a second side surface S2a of the second sub-conductive layer MP4b, and a third side surface S3a of the third sub-conductive layer MP4c that define a side surface SSa of each of a third tip portion TP3a and a fourth tip portion TP4a may not be aligned with one another. For example, the second side surface S2a may have a shape recessed with respect to (or from) the first side surface S1a and the third side surface S3a.

The shapes of the first to third side surfaces S1a, S2a, and S3a may vary according to components of an etchant used in a process of forming the first electrode AE or the materials of the first sub-conductive layer MP4a, the second sub-conductive layer MP4b, and the third sub-conductive layer MP4c. For example, the etchant may include a phosphoric acid-based etching composition, the first sub-conductive layer MP4a and the third sub-conductive layer MP4c may include titanium, and the second sub-conductive layer MP4b may include aluminium.

In an embodiment, a bottom surface GV-B of the second groove GV2 and a side surface GV-Sa connected to the bottom surface GV-B may be defined (or formed) by an insulating layer (or single layer), for example, the fourth insulating layer 40. The fourth insulating layer 40 may be an organic insulating layer.

The second groove GV2 and the valleys VP1a and VP2a may be formed by the same process. Accordingly, the shape of the second groove GV2 may be similar to the shapes of the valleys VP1a and VP2a. For example, the taper angle AG2 at which the valley tapered surface VTSa is inclined with respect to the plane aligned with the valley bottom surface VBS may be substantially the same as the angle AG4 of the side surface GV-Sa with respect to a plane aligned with the bottom surface GV-B.

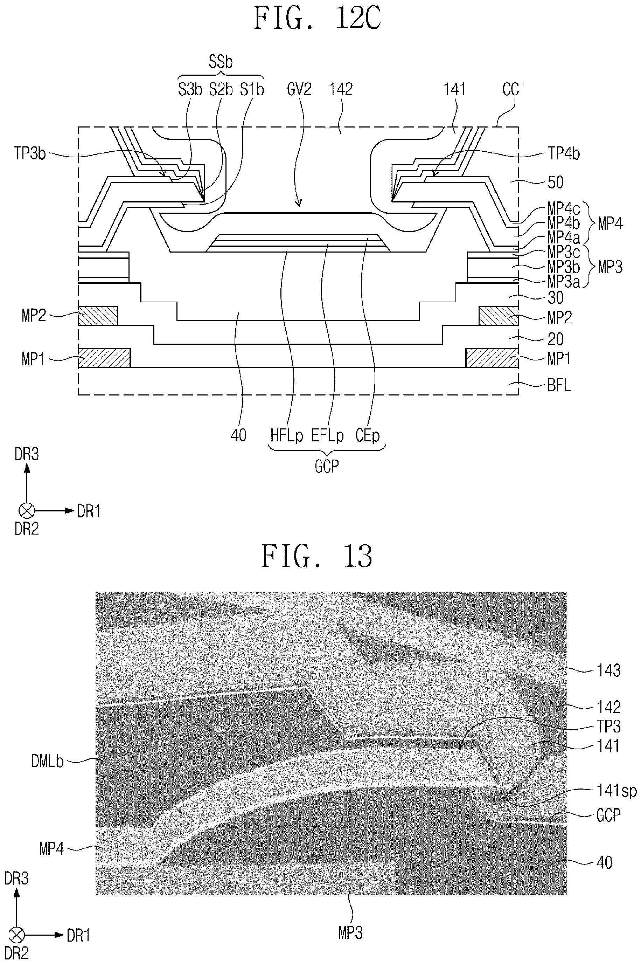

FIG. 12C is a schematic sectional view of the display panel DP (refer to FIG. 11A) according to an embodiment.

Referring to FIGS. 8B and 12C, the fourth conductive layer MP4 may have a multi-layer structure. For example, the fourth conductive layer MP4 may include a first sub-conductive layer MP4a, a second sub-conductive layer MP4b, and a third sub-conductive layer MP4c.

In an embodiment, a first side surface S1b of the first sub-conductive layer MP4a, a second side surface S2b of the second sub-conductive layer MP4b, and a third side surface S3b of the third sub-conductive layer MP4c that define a side surface SSb of each of a third tip portion TP3b and a fourth tip portion TP4b may not be aligned with one another. For example, the second side surface S2b may have a shape protruding with respect to (or from) the first side surface S1b and the third side surface S3b.

FIG. 13 is an image of a portion of the display panel DP (refer to FIG. 1A) according to an embodiment.

Referring to FIGS. 12A and 13, the thickness 141-t2 of a portion of the first encapsulation layer 141 disposed under the third tip portion TP3 and the fourth tip portion TP4 may be less than the thickness 141-11 of a portion of the first encapsulation layer 141 disposed on the third tip portion TP3 and the fourth tip portion TP4. Accordingly, a certain space 141sp may be defined in a region under each of the third tip portion TP3 and the fourth tip portion TP4 by the first encapsulation layer 141. The space 141sp may be filled with the material of the second encapsulation layer 142.

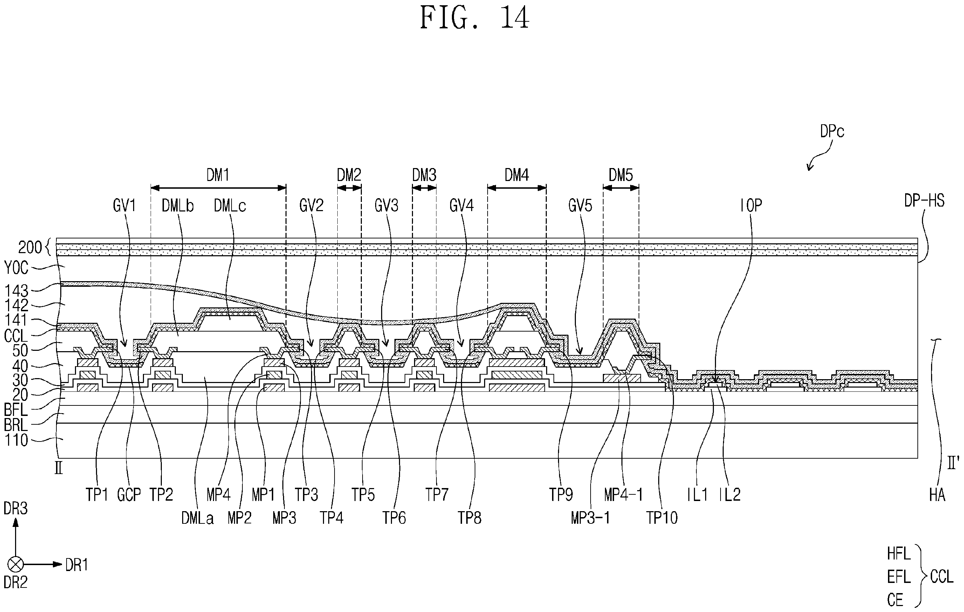

FIG. 14 is a schematic sectional view of a display panel DPc according to an embodiment. In describing FIG. 14, components identical to the components described with reference to FIG. 11A will be assigned with identical reference numerals, and descriptions thereabout will be omitted for descriptive convenience.

Referring to FIG. 14, the display panel DPc may further include a cover layer YOC. The cover layer YOC may be disposed on the third encapsulation layer 143. The cover layer YOC may be a layer provided to improve a step of a region adjacent to a hole HA. The cover layer YOC may include an organic material, but embodiments are not limited thereto. The cover layer YOC may be referred to as the compensation layer, the step compensation layer, the planarization layer, or the partial planarization layer.

A sensor layer 200 may be disposed on the cover layer YOC. The cover layer YOC may be disposed in the region adjacent to the hole HA to provide a flat base surface. Accordingly, the sensor layer 200 may be readily formed on the flat surface.

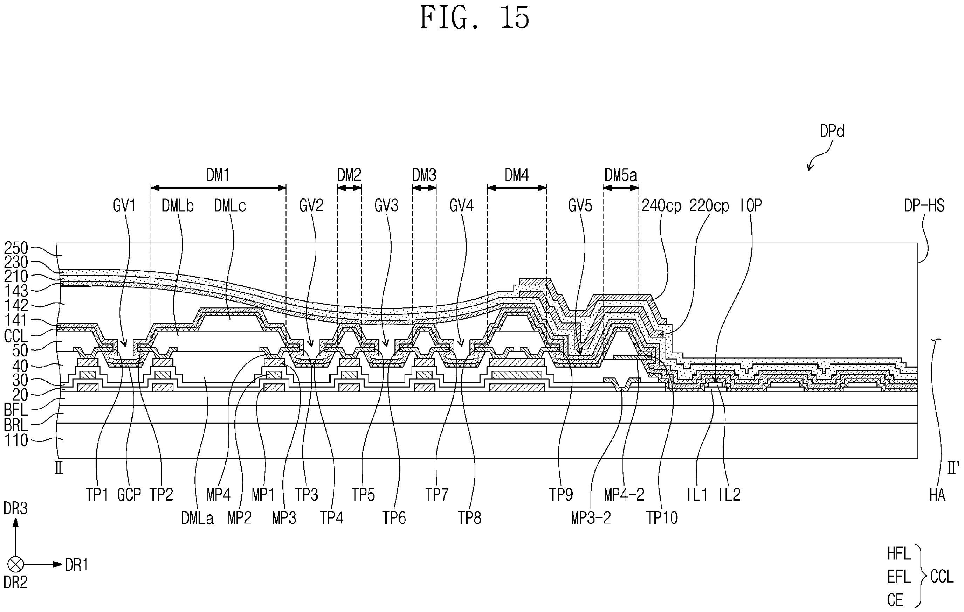

FIG. 15 is a schematic sectional view of a display panel DPd according to an embodiment. In describing FIG. 15, components identical to the components described with reference to FIG. 11A will be assigned with identical reference numerals, and descriptions thereabout will be omitted for descriptive convenience.

Referring to FIG. 15, the display panel DPd may include dams DM1, DM2, DM3, DM4, and DM5a and inorganic dams IOP adjacent to a hole HA. The dams DM1, DM2, DM3, DM4, and DM5a may include the first dam DM1, the second dam DM2, the third dam DM3, the fourth dam DM4, and the fifth dam DM5a.

Among the first to fifth dams DM1, DM2, DM3, DM4, and DM5a, the fifth dam DM5a may be disposed closest to the hole HA. The fifth dam DM5a may include a second insulating layer 20, a third insulating layer 30, a third conductive layer MP3-2, a first dam layer DMLa, a fourth conductive layer MP4-2, and a second dam layer DMI,b.

In an embodiment, the fourth conductive layer MP4-2 of the fifth dam DM5a may not be brought into contact with the third conductive layer MP3-2. Accordingly, the continuity of the fourth insulating layer 40 may not be broken in the region where the fifth dam DM5a is disposed. A tenth tip portion TP10 protruding toward the hole HA may be disposed in the fifth dam DM5a. The tenth tip portion TP10 may prevent a crack progressing from a sidewall DP-HS from propagating into the display panel DPd. Accordingly, the fifth dam DM5 may be referred to as the crack dam.

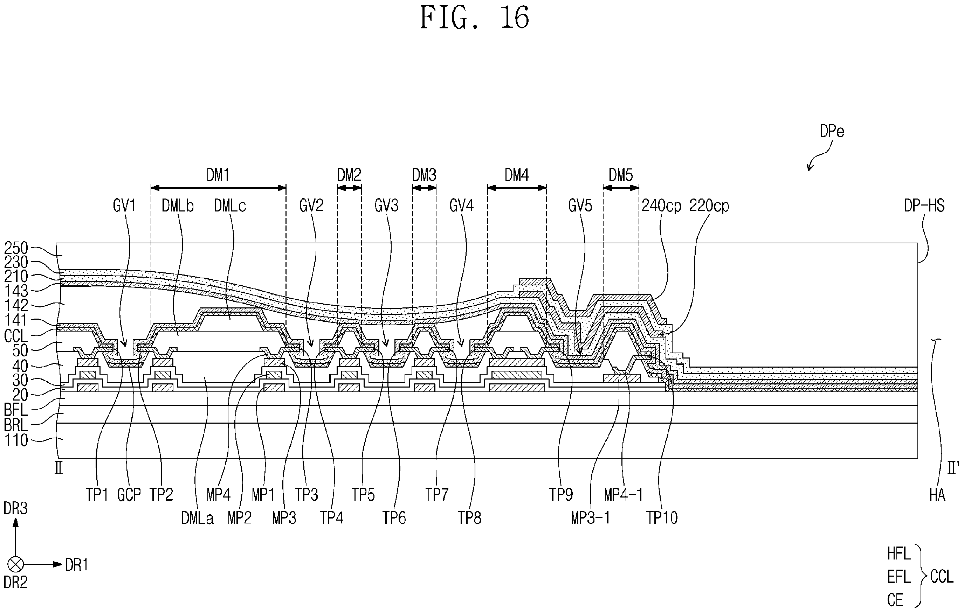

FIG. 16 is a schematic sectional view of a display panel DPe according to an embodiment. In describing FIG. 16, components identical to the components described with reference to FIG. 11A will be assigned with identical reference numerals, and descriptions thereabout will be omitted for descriptive convenience.

Referring to FIG. 16, the display panel DPe may include dams DM1, DM2, DM3, DM4, and DM5 adjacent to a hole HA. When compared to the display panel DP of FIG. 11A, the display panel DPe may not include the inorganic dams IOP. As the inorganic dams IOP are omitted, the area of a non-display region around the hole HA may be reduced. For example, as the inorganic dams IOP are omitted, a process may be simplified.

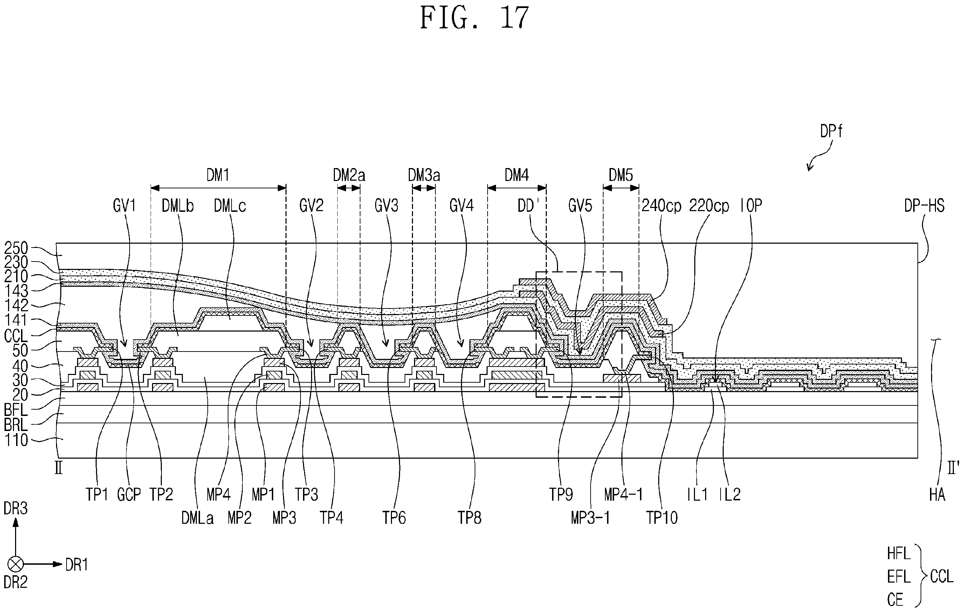

FIG. 17 is a schematic sectional view of a display panel DPf according to an embodiment. In describing FIG. 17, components identical to the components described with reference to FIG. 11A will be assigned with identical reference numerals, and descriptions thereabout will be omitted for descriptive convenience.

Referring to FIG. 17, the display panel DPf may include dams DM1, DM2a, DM3a, DM4, and DM5 and inorganic dams IOP adjacent to a hole HA. The dams DM1, DM2a, DM3a, DM4, and DM5 may include the first dam DM1, the second dam DM2a, the third dam DM3a, the fourth dam DM4, and the fifth dam DM5.

Each of the first to fourth dams DM1, DM2a, DM3a, and DM4 may be disposed between grooves. In an embodiment, among the first to fourth dams DM1, DM2a, DM3a, and DM4, the first dam DM1 and the fourth dam DM4 may have the greatest height (or thickness). The second dam DM2a and the third dam DM3a may have a smaller height or thickness than the first and fourth dams DM1 and DM4.

In an embodiment, each of the first dam DM1 and the fourth dam DM4 may have a double wing structure including tip portions protruding in opposite directions. The second dam DM2a and the third dam DM3a may have a single wing structure including a tip portion protruding in one direction. For example, when compared to the display panel DP of FIG. 11A, the display panel DPf may not include the fifth tip portion TP5 and the seventh tip portion TP7. However, this is an example, and one of the second dam DM2a and the third dam DM3a may have a double wing structure including tip portions protruding in opposite directions, and the other one of the second dam DM2a and the third dam DM3a may have a single wing structure.

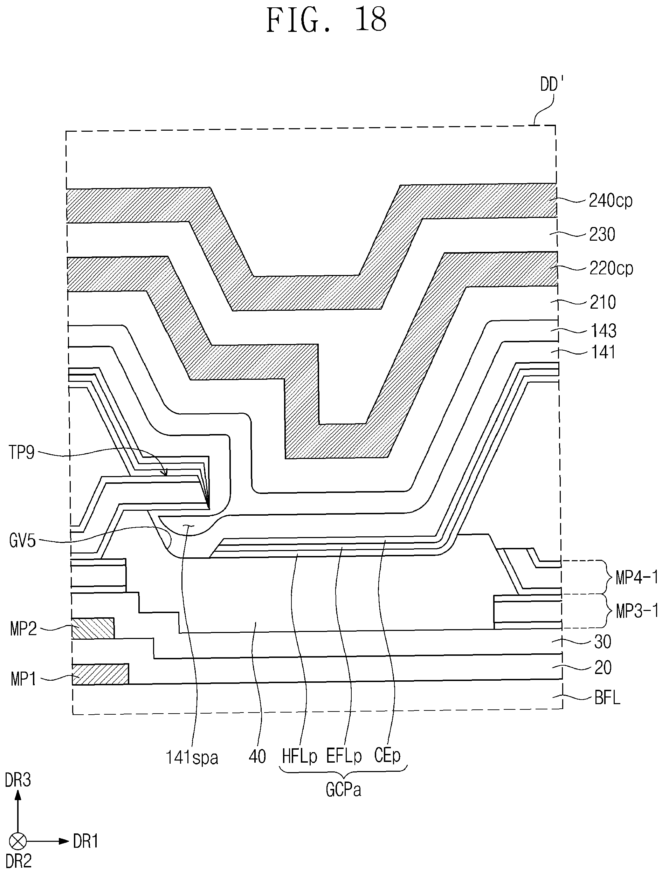

FIG. 18 is an enlarged schematic sectional view illustrating a portion of a display panel DPf (refer to FIG. 17) according to an embodiment. For example, FIG. 18 is an enlarged schematic sectional view illustrating region DD' illustrated in FIG. 17.

Referring to FIGS. 17 and 18, disconnected layers GCPa may be disposed in a fifth groove GV5. The disconnected layers GCPa may be disconnected by a ninth tip portion TP9 and may extend above the fifth dam DM5.

A first encapsulation layer 141 may cover the fifth groove GV5. A certain space 141spa may be defined under the ninth tip portion TP9. The space 141spa may have an open structure that is not completely closed by the first encapsulation layer 141.

During a process of forming a second encapsulation layer 142, a monomer may or may not be disposed in the region where the fifth groove GV5 is defined. Accordingly, the space 141spa may or may not be filled with the material of the second encapsulation layer 142.

Although FIG. 18 illustrates an example that the space 141spa is filled with a material of a third encapsulation layer 143, embodiments are not limited thereto. For example, the space 141spa may have a structure completely closed by the first encapsulation layer 141 and the third encapsulation layer 143. In the case that the space 141spa has the structure closed by the first encapsulation layer 141 and the third encapsulation layer 143, the space 141spa may contain a gas used during a process of forming the first encapsulation layer 141, or may be in a vacuum state.

According to an embodiment, first and second clad patterns 220cp and 240cp may be disposed in a region overlapping the fifth groove GV5. Accordingly, even though the third encapsulation layer 143 is cracked or oxidized, moisture and oxygen may be blocked by the first and second clad patterns 220cp and 240cp. Accordingly, the product reliability of the display panel DPf may be improved.

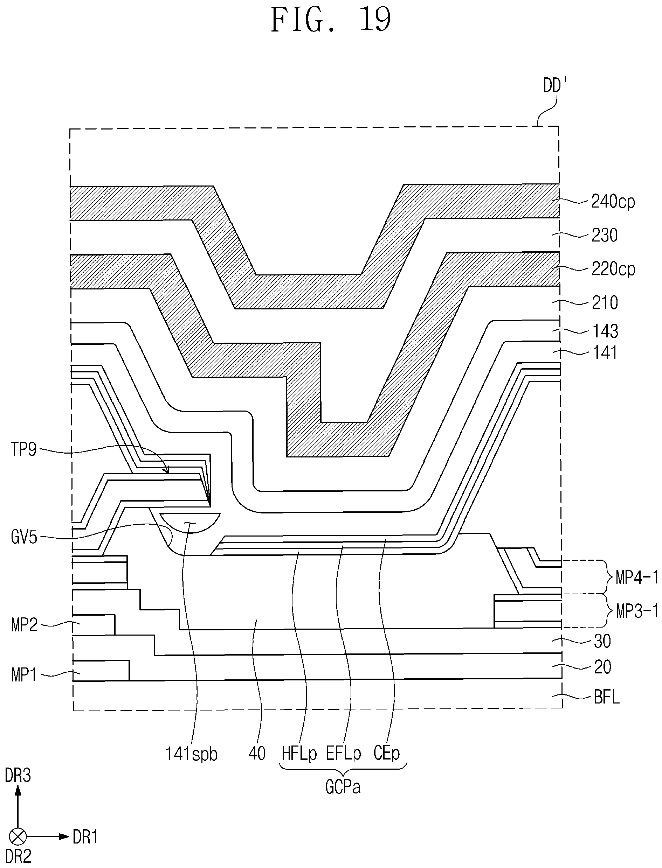

FIG. 19 is an enlarged schematic sectional view illustrating a portion of a display panel DPf (refer to FIG. 17) according to an embodiment. For example, FIG. 19 is an enlarged schematic sectional view illustrating region DD' illustrated in FIG. 17. In describing FIG. 19, components identical to the components described with reference to FIG. 18 will be assigned with identical reference numerals, and descriptions thereabout will be omitted for descriptive convenience.

Referring to FIGS. 17 and 19, a first encapsulation layer 141 may cover a fifth groove GV5. A certain space 141spb may be defined under the ninth tip portion TP9. The space 141spb may have a structure completely closed by the first encapsulation layer 141. For example, another material, for example, a material of a second encapsulation layer 142 or a material of a third encapsulation layer 143 may not be disposed in the space 141spb. For example, the space 141spb may contain a gas used during a process of forming the first encapsulation layer 141, or may be in a vacuum state.

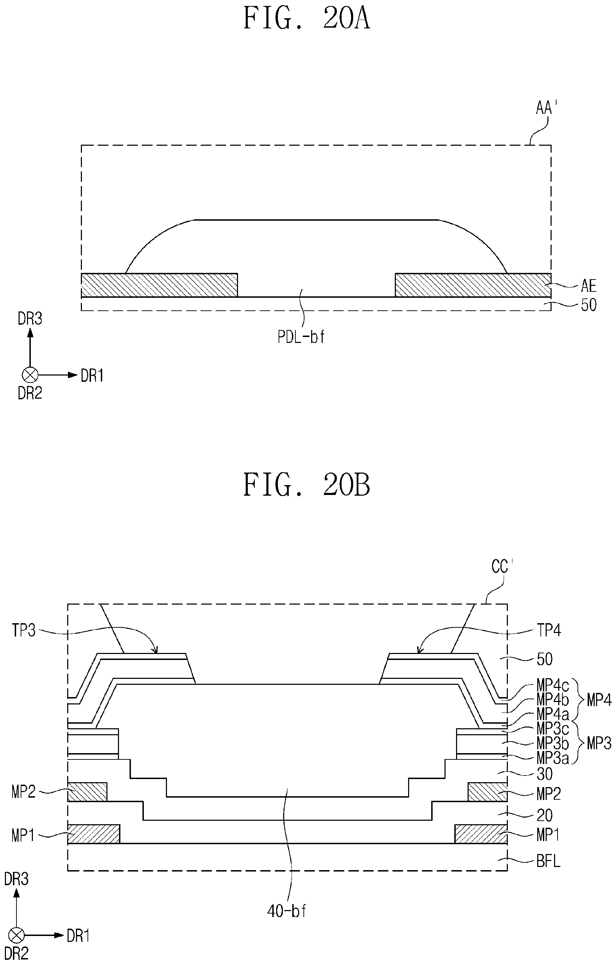

FIGS. 20A, 20B, 21A, 21B, 22A, 22B, 23A, 23B, 24A, and 24B are schematic sectional views illustrating some steps of a display panel manufacturing process according to an embodiment.

FIGS. 20A, 21A, 22A, 23A, and 24A are sectional views illustrating a process of forming valleys VP in a preliminary pixel defining layer PDL-bf (e.g., in an upper surface of the preliminary pixel defining layer PDL-bf). FIGS. 20B, 21B, 22B, 23B, and 24B are schematic sectional views illustrating a process of forming a second groove GV2 on a preliminary insulating layer 40-bf (e.g., in an upper surface of the preliminary insulating layer 40-bf). The following description may be identically applied to the first groove GV1, the third groove GV3, and the fourth groove GV4 described above.

In FIGS. 20A and 20B, a region corresponding to region AA' and a region corresponding to region CC' that are placed in the same process are illustrated. Referring to FIG. 20A, a first electrode AE may be formed on a fifth insulating layer 50, and the preliminary pixel defining layer PDL-bf may be formed on the first electrode AE. Referring to FIG. 20B, a third tip portion TP3 and a fourth tip portion TP4 that are not covered by the fifth insulating layer 50 are defined. A portion of the preliminary insulating layer 40-bf is exposed between the third tip portion TP3 and the fourth tip portion TP4. The preliminary insulating layer 40-bf is a layer corresponding to the fourth insulating layer 40 (refer to FIG. 11A).

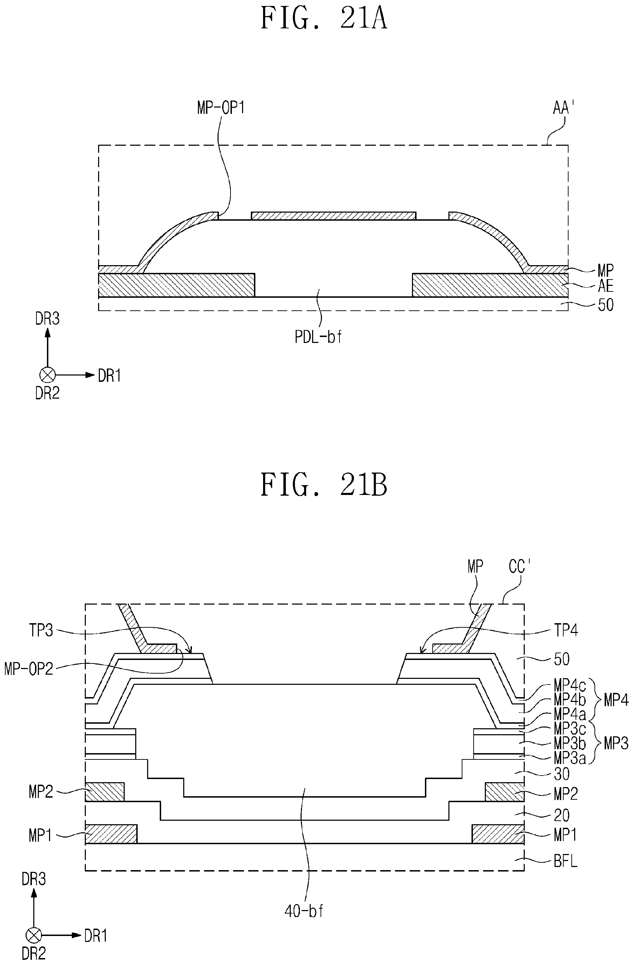

Referring to FIGS. 21A and 21B, a mask layer MP may cover the first electrode AE, the preliminary pixel defining layer PDL-bf, the fifth insulating layer 50, the third tip portion TP3, and the fourth tip portion TP4. The mask layer MP may have a first opening MP-OP1 and a second opening MP-OP2 defined therein. The first opening MP-OP1 may overlap the preliminary pixel defining layer PDL-bf, and the second opening MP-OP2 may overlap a portion of the preliminary insulating layer 40-bf, a portion of the third tip portion TP3, and a portion of the fourth tip portion TP4. The mask layer MP may include indium gallium zinc oxide (IGZO), but embodiments are not limited thereto.

In an embodiment, a sidewall defining the second opening MP-OP2 of the mask layer MP may be spaced apart from an end portion of the third tip portion TP3 and an end portion of the fourth tip portion TP4. For example, the upper surface of the third tip portion TP3 and the upper surface of the fourth tip portion TP4 may be exposed by at least 0.5 micrometers or more.

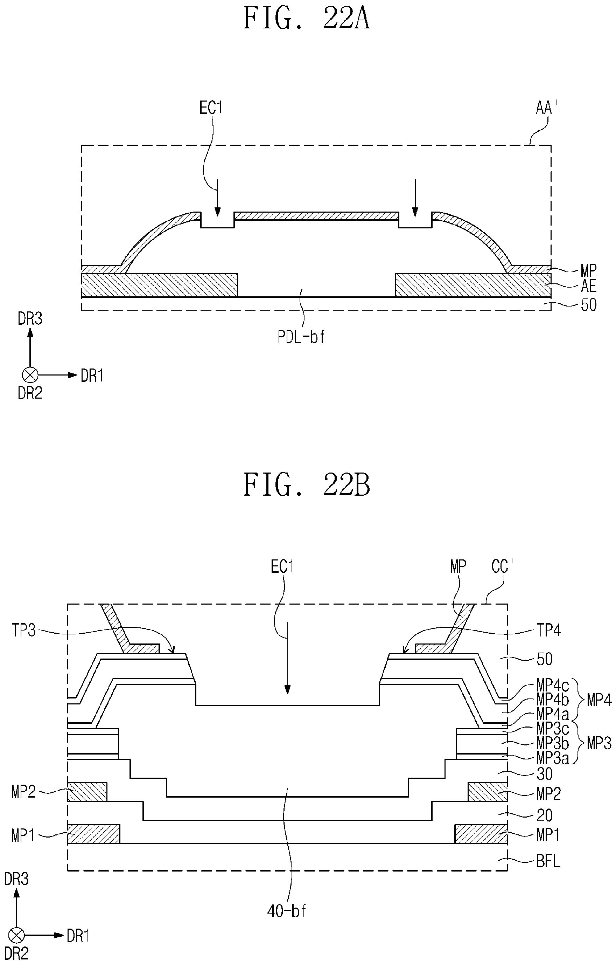

Referring to FIGS. 22A and 22B, first etching EC1 may be simultaneously performed on the preliminary pixel defining layer PDL-bf and the preliminary insulating layer 40-bf. The first etching EC1 may be dry etching and may be anisotropic etching having specific orientation. Grooves having substantially the same depth may be formed in the preliminary pixel defining layer PDL-bf and the preliminary insulating layer 40-bf (e.g., in upper surfaces thereof) by the first etching EC1.

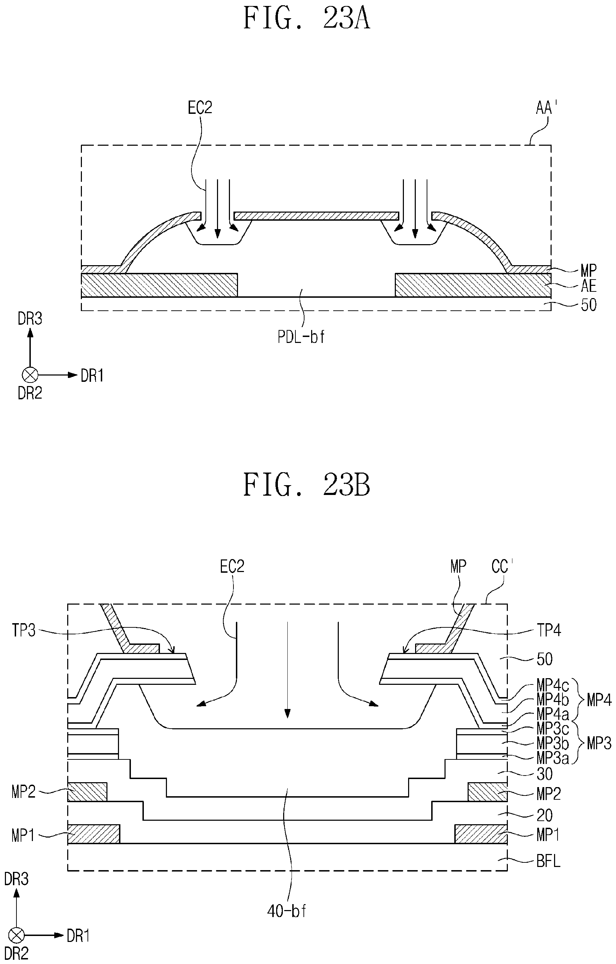

Referring to FIGS. 23A and 23B, second etching EC2 may be simultaneously performed on the preliminary pixel defining layer PDL-bf and the preliminary insulating layer 40-bf. The second etching EC2 may be dry etching and may be isotropic etching. Spaces formed by the first etching EC1 and the second etching EC2 may have an undercut shape with respect to the mask layer MP or the third and fourth tip portions TP3 and TP4.

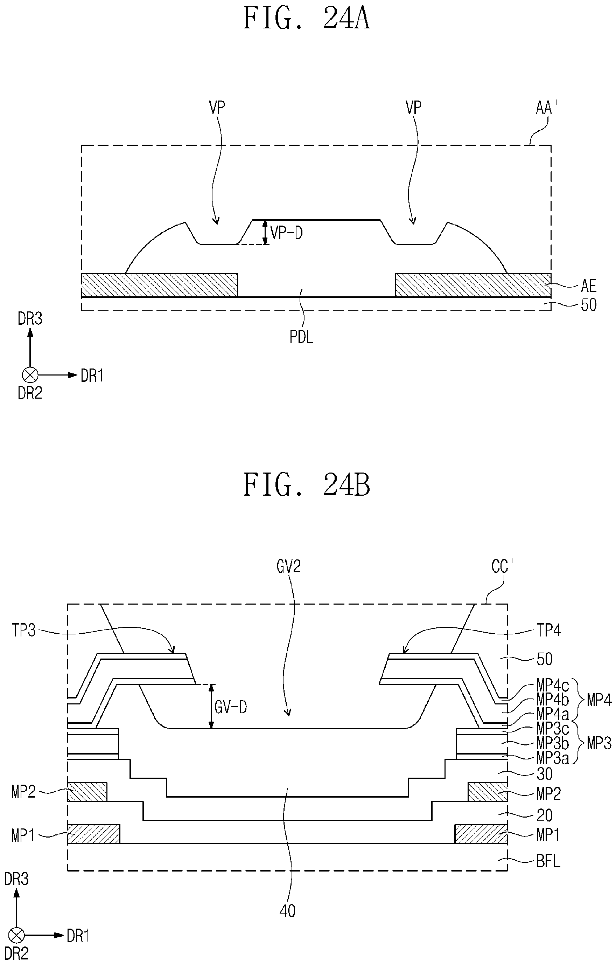

Referring to FIGS. 24A and 24B, in the case that the mask layer MP is removed, a pixel defining layer PDL having the valleys VP defined therein and a fourth insulating layer 40 having the second groove GV2 defined therein may be formed. The valleys VP and the second groove GV2 formed by the same process may have similar shapes. For example, the depths VP-D of the valleys VP may be substantially the same as the depth GV-D of the second groove GV2 defined by (or formed in) the fourth insulating layer 40.

In an embodiment, the pixel defining layer PDL may include a black coloring agent. The black coloring agent may include carbon black, metal such as chromium, or oxide thereof. For example, in the case that the pixel defining layer PDL is etched to form the valleys VP, an uneven surface may be formed by the black coloring agent. For example, the fourth insulating layer 40 may not include the black coloring agent. Accordingly, the roughness of the bottom surface of the second groove GV2 may be lower than the roughness of the bottom surface of each of the valleys VP. For example, the bottom surface of the second groove GV2 may be smoother than the bottom surfaces of the valleys VP.

In an embodiment, the first to fifth grooves GV1, GV2, GV3, GV4, and GV5 (refer to FIG. 11A) may be formed by the same process as the process of forming the valleys VP. Accordingly, an additional process for forming the first to fifth grooves GV1, GV2, GV3, GV4, and GV5 may be omitted. For example, the number of masks used during the process of forming the display panel DP may be decreased, and the manufacturing cost of the display panel DP may be reduced.

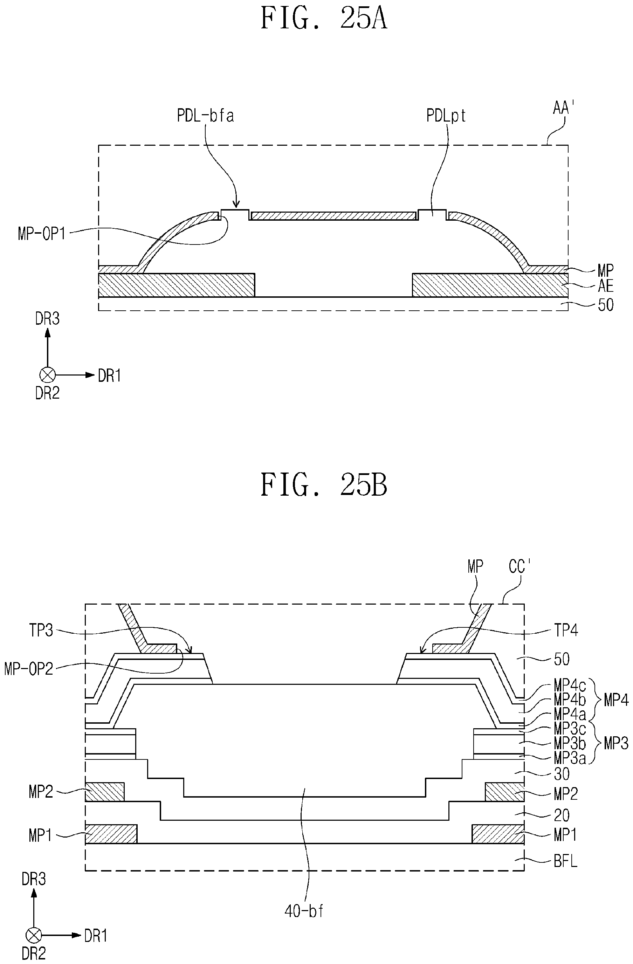

FIGS. 25A, 25B, 26A, 26B, 27A, 27B, 28A, and 28B are schematic sectional views illustrating some steps of a display panel manufacturing process according to an embodiment.

FIGS. 25A, 26A, 27A, and 28A are schematic sectional views illustrating a process of forming valleys VP in a preliminary pixel defining layer PDL-bfa (e.g., in an upper surface of the preliminary pixel defining layer PDL-bfa). FIGS. 25B, 26B, 27B, and 28B are schematic sectional views illustrating a process of forming a second groove GV2a in a preliminary insulating layer 40-bf (e.g., in an upper surface of the preliminary insulating layer 40-bf). The following description may be identically applied to the first groove GV1, the third groove GV3, and the fourth groove GV4 described above.

In FIGS. 25A and 25B, a region corresponding to region AA' and a region corresponding to region CC' that are placed in the same process are illustrated. Referring to FIGS. 25A and 25B, a first electrode AE may be formed on a fifth insulating layer 50, and the preliminary pixel defining layer PDL-bfa having an opening OP formed therein may be formed on the first electrode AE. In an embodiment, the preliminary pixel defining layer PDL-bfa may include protruding portions PDLpt. The protruding portions PDLpt may overlap the positions in which the valleys VP, which will be described below, are to be formed. A third tip portion TP3 and a fourth tip portion TP4 that are not covered by the fifth insulating layer 50 are defined. A portion of the preliminary insulating layer 40-bf is exposed between the third tip portion TP3 and the fourth tip portion TP4. The preliminary insulating layer 40-bf is a layer corresponding to the fourth insulating layer 40 (refer to FIG. 11A).

A mask layer MP may cover the first electrode AE, the preliminary pixel defining layer PDL-bfa, the fifth insulating layer 50, the third tip portion TP3, and the fourth tip portion TP4. The mask layer MP may have a first opening MP-OP1 and a second opening MP-OP2 defined therein. The first opening MP-OP1 may overlap the preliminary pixel defining layer PDL-bfa, and the second opening MP-OP2 may overlap a portion of the preliminary insulating layer 40-bf, a portion of the third tip portion TP3, and a portion of the fourth tip portion TP4. The mask layer MP may include indium gallium zinc oxide (IGZO), but embodiments are not limited thereto.

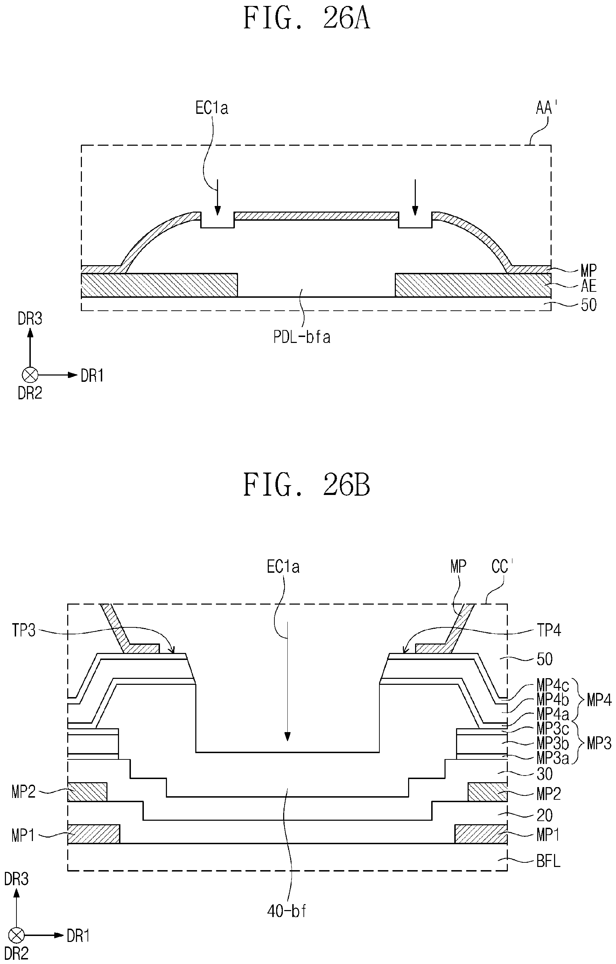

Referring to FIGS. 26A and 26B, first etching EC1a may be simultaneously performed on the preliminary pixel defining layer PDL-bfa and the preliminary insulating layer 40-bf. The first etching EC1a may be dry etching and may be anisotropic etching having specific orientation. In an embodiment, the preliminary pixel defining layer PDL-bfa may include the protruding portions PDLpt. Accordingly, even though the preliminary pixel defining layer PDL-bfa and the preliminary insulating layer 40-bf are identically etched in the same process, the depth of grooves (i.e., valleys) formed in the preliminary pixel defining layer PDL-bfa may be shallower than the depth of a groove formed in the preliminary insulating layer 40-bf.

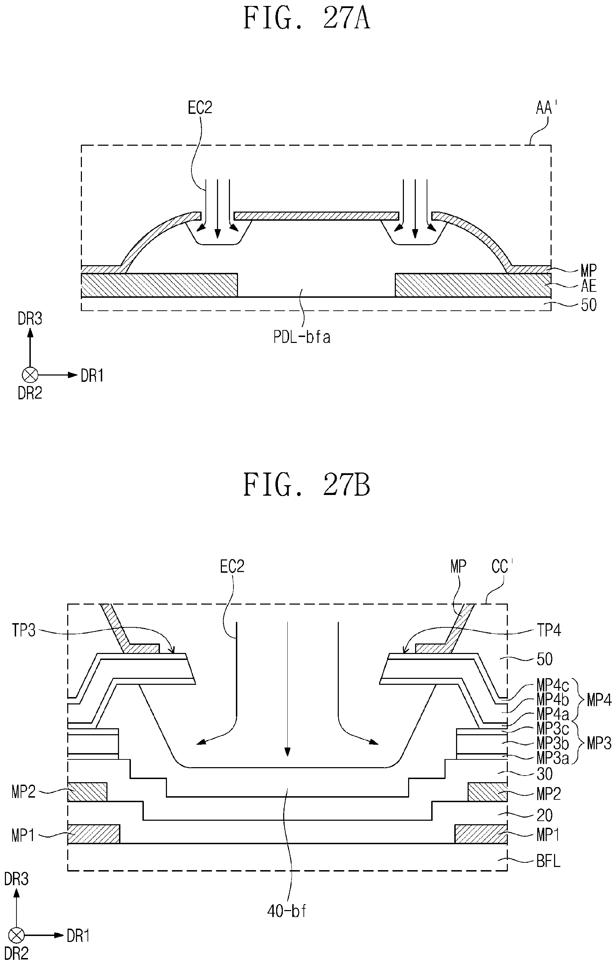

Referring to FIGS. 27A and 27B, second etching EC2 may be simultaneously performed on the preliminary pixel defining layer PDL-bfa and the preliminary insulating layer 40-bf. The second etching EC2 may be dry etching and may be isotropic etching. Spaces formed by the first etching EC1a and the second etching EC2 may have an undercut shape with respect to the mask layer MP or the third and fourth tip portions TP3 and TP4.

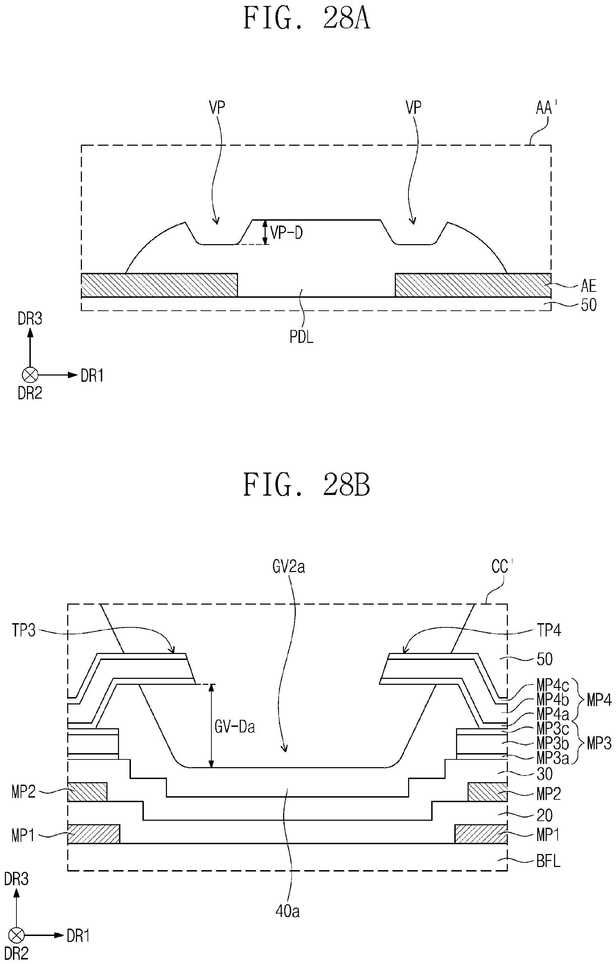

Referring to FIGS. 28A and 28B, in the case that the mask layer MP is removed, a pixel defining layer PDL having the valleys VP defined therein and a fourth insulating layer 40a having the second groove GV2a defined therein may be formed. The valleys VP and the second groove GV2a formed by the same process may have similar shapes. Since the preliminary pixel defining layer PDL-bfa includes the protruding portions PDLpt before the process, the depths VP-D of the valleys VP may be shallower than the depth GV-Da of the second groove GV2a defined by (or formed in) the fourth insulating layer 40a.

As described above, the grooves and the valleys formed by the same process may be defined in the display panel. Accordingly, an additional process for forming the grooves may be omitted. For example, the number of masks used in the process of forming the display panel may be decreased, and the manufacturing cost of the display panel may be reduced.

The path along which the etchant is able to infiltrate in the case that the hole of the display panel is processed may be shielded by the dams. Furthermore, the path may be additionally shielded by the crack dam disposed closest to the hole. For example, each of the dams defined between the grooves may include the tip portions protruding in the opposite directions. Accordingly, even though the depths of the grooves are decreased, as many as possible of the tip portions may be provided, and thus the common layer may be stably disconnected. Thus, the reliability of the display panel may be further improved.

The region overlapping the groove not covered by the organic encapsulation layer among the grooves may be covered by at least one clad pattern. Accordingly, even though the inorganic encapsulation layer is cracked by the flexure of the groove or oxidized, moisture and oxygen may be blocked by the clad pattern. Thus, the product reliability of the display panel may be improved.

While the disclosure has been described with reference to embodiments thereof, it will be apparent to those of ordinary skill in the art that various changes and modifications may be made thereto without departing from the scope of the disclosure as set forth in the following claims.

## Claims

1. A display panel comprising:
a base layer having a hole;
a circuit layer disposed on the base layer, the circuit layer including a pixel circuit and a plurality of insulating layers;
an element layer disposed on the circuit layer, the element layer including a light emitting element electrically connected to the pixel circuit and a pixel defining layer defining an emissive region; and
an encapsulation layer covering the element layer, wherein
the circuit layer further includes a groove surrounding the hole,
the pixel defining layer includes a valley surrounding at least a portion of the emissive region, and
a bottom surface of the groove and side surfaces of the groove connected to the bottom surface are formed by an insulating layer among the plurality of insulating layers.

2. The display panel of claim 1, wherein
the circuit layer further includes:
a first tip portion surrounding the hole, and
a second tip portion surrounding the first tip portion, and
the first tip portion and the second tip portion protrude from the respective side surfaces of the groove.

3. The display panel of claim 2, wherein a depth of the valley is substantially the same as a height of the first tip portion, which is measured from the bottom surface of the groove to a bottom surface of the first tip portion.

4. The display panel of claim 3, wherein a difference between the height of the first tip portion and a width of the first tip portion is less than about 0.15 micrometers.

5. The display panel of any one of claims 1 to 4, wherein each of the side surfaces of the groove includes a curved surface extending from the bottom surface and a tapered surface extending from the curved surface.

6. The display panel of claim 5, wherein
the valley is formed by a valley bottom surface, a valley curved surface extending from the valley bottom surface, and a valley tapered surface extending from the valley curved surface, and
the valley curved surface has substantially the same shape as the curved surface of the groove, optionally wherein an angle between the valley bottom surface and the valley tapered surface is substantially the same as an angle between the bottom surface of the groove and the tapered surface of the groove.

7. The display panel of any one of claims 1 to 6, wherein
the groove includes a plurality of grooves, and
the encapsulation layer includes:
a first encapsulation layer covering the plurality of grooves,
a second encapsulation layer disposed on the first encapsulation layer to overlap some of the plurality of grooves and so as not to overlap other grooves of the plurality of grooves, and
a third encapsulation layer disposed on the second encapsulation layer to cover the plurality of grooves.

8. The display panel of claim 7, further comprising:
a sensor layer disposed on the encapsulation layer, the sensor layer including:
a first sensor conductive layer,
a sensor insulating layer disposed on the first sensor conductive layer, and
a second sensor conductive layer disposed on the sensor insulating layer,
wherein at least one of the first sensor conductive layer and the second sensor conductive layer includes a clad pattern overlapping the other grooves.

9. The display panel of claim 8, wherein:
(i) the circuit layer further includes a crack dam disposed between the groove and the hole,
the crack dam includes a tip portion protruding toward the hole, and
the clad pattern overlaps the crack dam and the tip portion; and/or
(ii) the display panel further comprises:
a cover layer disposed on the third encapsulation layer and overlapping the plurality of grooves.

10. The display panel of any one of claims 1 to 7, wherein
the circuit layer further includes a crack dam disposed between the groove and the hole, and
the crack dam includes a tip portion protruding toward the hole.

11. The display panel of any one of claims 1 to 10, wherein
the circuit layer further includes at least one inorganic pattern disposed between the groove and the hole, and
the at least one inorganic pattern includes the same materials as inorganic insulating layers among the plurality of insulating layers of the circuit layer.

12. The display panel of any one of claims 1 to 11, wherein the insulating layer among the plurality of insulating layers is an organic insulating layer.

13. The display panel of any one of claims 1 to 12, wherein
the light emitting element includes:
a first electrode,
an intermediate layer disposed on the first electrode, and
a second electrode disposed on the intermediate layer, and
a portion of the intermediate layer and a portion of the second electrode are disposed in the valley, optionally wherein
the intermediate layer includes:
a first functional layer,
an emissive layer disposed on the first functional layer, and
a second functional layer disposed on the emissive layer, and
a portion of the first functional layer, a portion of the second functional layer, and a portion of the second electrode are disposed in the groove.

14. The display panel of any one of claims 1 to 13, wherein the bottom surface of the groove has a lower roughness than a valley bottom surface of the valley.

15. The display panel of any one of claims 1 to 12, wherein
the light emitting element includes:
a first electrode,
an intermediate layer disposed on the first electrode, and
a second electrode disposed on the intermediate layer, and
an indium-gallium-zinc oxide residue is disposed on an upper surface of the first electrode.
